# EUROPEAN PATENT APPLICATION

(11) **EP 4 685 783 A1**
(43) Date of publication of application: **28.01.2026**
(21) Application number: 25190493.4
(22) Date of filing: 18.07.2025
(51) Int. Cl.: G09G 3/3233, H10K 59/121

(54) **DISPLAY DEVICE AND ELECTRONIC DEVICE INCLUDING THE SAME**

(30) Priority: 25.07.2024 KR 20240098891; 07.03.2025 KR 20250030153
(71) Applicant: Samsung Display Co., Ltd., Yongin-si, Gyeonggi-do 17113 (KR)
(72) Inventor: SON, Sunkwun, Giheung-gu, Yongin-si, Gyeonggi-do 17113 (KR); LEE, Cheol-Gon, Giheung-gu, Yongin-si, Gyeonggi-do 17113 (KR)
(74) Representative: Dr. Weitzel & Partner

(57) **Abstract**

A display device includes a light-emitting element (LE), a first transistor (T1) that generates a driving current applied to the light-emitting element and includes a first channel area, a second transistor (T2) that applies a data voltage to the first transistor in response to a first gate signal (GW) and includes a second channel area disposed in a different layer from the first channel area, a third transistor (T3) that applies a power voltage (ELVDD) to the first transistor in response to a second gate signal (GC) and includes a third channel area disposed in a different layer from each of the first channel area and the second channel area, and a fourth transistor (T4) that electrically connects the first transistor and the light-emitting element in response to a light-emitting signal (EM) and includes a fourth channel area disposed in a different layer from each of the first channel area and the second channel area.

## Description

The present invention relates to a display device and an electronic device including the same. More specifically, the present invention relates to a high-resolution display device and an electronic device including the same.

A display device displays an image to provide visual information to a user. The display device may be operated by thin film transistors, capacitors, and lines having a complex connection relationship with each other.

Recently, as the demand for compact and high-resolution display devices is increasing, the demand for efficient space arrangement, connection structure, and driving method between thin film transistors, capacitors, and lines included in the display device, and improvement in quality of images implemented is increasing.

The present invention provides a display device with improved resolution. The invention is defined by the features of claim 1. The dependent claims and the description provide preferred embodiments.

Embodiments provide an electronic device including the display device.

A display device in accordance with the present invention includes a light-emitting element, a first transistor that generates a driving current applied to the light-emitting element and includes a first channel area, a second transistor that applies a data voltage to the first transistor in response to a first gate signal and includes a second channel area disposed in a different layer from the first channel area, a third transistor that applies a power voltage to the first transistor in response to a second gate signal and includes a third channel area disposed in a different layer from each of the first channel area and the second channel area, and a fourth transistor that electrically connects the first transistor and the light-emitting element in response to a light-emitting signal and includes a fourth channel area disposed in a different layer from each of the first channel area and the second channel area.

In an embodiment, the first channel area may be disposed in a first semiconductor layer, and the second channel area may be disposed in a second semiconductor layer on which the first semiconductor layer is disposed.

In an embodiment, the third channel area and the fourth channel area may be disposed in a third semiconductor layer disposed on the first semiconductor layer.

In an embodiment, the first semiconductor layer may be disposed between the second semiconductor layer and the third semiconductor layer.

In an embodiment, the first semiconductor layer may include a first semiconductor pattern including the first channel area, a first source area, and a first drain area, the second semiconductor layer may include a second semiconductor pattern including the second channel area, a second source area, and a second drain area, and at least partially overlapping the first semiconductor pattern in a plan view, and the third semiconductor layer may include a third semiconductor pattern including the third channel area, a third source area, and a third drain area, and at least partially overlapping each of the first semiconductor pattern and the second semiconductor pattern in the plan view, and a fourth semiconductor pattern including the fourth channel area, a fourth source area, and a fourth drain area, at least partially overlapping each of the first semiconductor pattern and the second semiconductor pattern in the plan view, and spaced apart from the third semiconductor pattern.

In an embodiment, the display device may further include a first capacitor pattern disposed in a first conductive layer disposed between the first semiconductor layer and the second semiconductor layer, the first capacitor pattern may at least partially overlap the second drain area in the plan view, and the second drain area and the first capacitor pattern may define a first sub-capacitor.

In an embodiment, the display device may further include a second capacitor pattern disposed in a second conductive layer disposed between the first conductive layer and the first semiconductor layer and a third capacitor pattern disposed in a third conductive layer disposed between the second conductive layer and the first semiconductor layer, the second capacitor pattern may at least partially overlap each of the second drain area and the first capacitor pattern in the plan view, the third capacitor pattern may at least partially overlap each of the second drain area, the first capacitor pattern, and the second capacitor pattern in the plan view, and the second capacitor pattern and the third capacitor pattern may define a second sub-capacitor.

In an embodiment, the display device may further include a first gate electrode disposed in a fourth conductive layer disposed between the first semiconductor layer and the third semiconductor layer, and the first gate electrode may at least partially overlap each of the first channel area, the second drain area, the first capacitor pattern, the second capacitor pattern, and the third capacitor pattern in the plan view.

In an embodiment, the display device may further include a fourth capacitor pattern disposed in a fifth conductive layer disposed between the fourth conductive layer and the third semiconductor layer, the fourth capacitor pattern may at least partially overlap each of the second drain area, the first capacitor pattern, the second capacitor pattern, the third capacitor pattern, and the first gate electrode in the plan view, and the first gate electrode and the fourth capacitor pattern may define a third sub-capacitor.

In an embodiment, the second drain area, the second capacitor pattern, and the first gate electrode may be electrically connected to each other, and the first capacitor pattern, the third capacitor pattern, and the fourth capacitor pattern may be electrically connected to each other.

In an embodiment, the first sub-capacitor, the second sub-capacitor, and the third sub-capacitor may at least partially overlap each other in the plan view.

In an embodiment, the display device may further include a first capacitor including a first electrode electrically connected to the first gate electrode and a second electrode electrically connected to the first capacitor pattern, and a second capacitor including a first electrode to which a reference voltage is applied and a second electrode electrically connected to the first capacitor.

In an embodiment, the first capacitor may include the first sub-capacitor, the second sub-capacitor, and the third sub-capacitor.

In an embodiment, the display device may further include a fifth capacitor pattern disposed in a sixth conductive layer disposed on the first conductive layer, the fifth capacitor pattern may at least partially overlap each of the second drain area, the first capacitor pattern, the second capacitor pattern, the third capacitor pattern, the first gate electrode, and the fourth capacitor pattern in the plan view, and the first capacitor pattern and the fifth capacitor pattern may define the second capacitor.

In an embodiment, the second capacitor may at least partially overlap each of the first sub-capacitor, the second sub-capacitor, and the third sub-capacitor in the plan view.

In an embodiment, the first semiconductor pattern and the first gate electrode may define the first transistor.

In an embodiment, the display device may further include a second gate electrode disposed in the first conductive layer, the second gate electrode may be spaced apart from the first capacitor pattern and at least partially overlap the second channel area in the plan view, and the second semiconductor pattern and the second gate electrode may define the second transistor.

In an embodiment, the display device may further include a third gate electrode disposed in a seventh conductive layer disposed on the third semiconductor layer, the third gate electrode may at least partially overlap the third channel area in the plan view, and the third semiconductor pattern and the third gate electrode may define the third transistor.

In an embodiment, the display device may further include a fourth gate electrode disposed in the seventh conductive layer, the fourth gate electrode may be spaced apart from the third gate electrode and at least partially overlap the fourth channel area, and the fourth semiconductor pattern and the fourth gate electrode may define the fourth transistor.

An electronic device in an embodiment of the invention includes a housing and a display device housed in the housing to display an image. The display device includes a light-emitting element, a first transistor that generates a driving current applied to the light-emitting element and includes a first channel area, a second transistor that applies a data voltage to the first transistor in response to a first gate signal and includes a second channel area disposed in a different layer from the first channel area, a third transistor that applies a power voltage to the first transistor in response to a second gate signal and includes a third channel area disposed in a different layer from each of the first channel area and the second channel area, and a fourth transistor that electrically connects the first transistor and the light-emitting element in response to a light-emitting signal and includes a fourth channel area disposed in a different layer from each of the first channel area and the second channel area.

In a display device in embodiments of the invention, transistors of a pixel circuit included in a display panel may be implemented as a multi-layer structure stacked in one direction. In addition, a capacitor of the pixel circuit may be implemented as a multi-capacitor structure stacked in one direction. Accordingly, degree of integration of the pixel circuits may be further improved, and resolution of the display device may be further improved.

The above and other embodiments, advantages and features of this invention will become more apparent by describing in further detail embodiments thereof with reference to the accompanying drawings.
FIG. 1 is a plan view illustrating an embodiment of a display device according to the invention.
FIG. 2 is a block diagram illustrating the display device of FIG. 1.
FIG. 3 is a circuit diagram illustrating an embodiment of a pixel included in the display device of FIG. 1.
FIG. 4 is a cross-sectional view illustrating an embodiment of a display panel included in the display device of FIG. 1.
FIGS. 5 to 31 are layout diagrams illustrating the display panel of FIG. 4.
FIG. 32 is an exploded perspective view illustrating an embodiment of an electronic device according to the invention.

Hereinafter, embodiments of the invention will be described in more detail with reference to the accompanying drawings. The same reference numerals are used for the same components in the drawings, and redundant descriptions of the same components will be omitted.

It will be understood that when an element is referred to as being "on" another element, it may be directly on the other element or intervening elements may be present therebetween. In contrast, when an element is referred to as being "directly on" another element, there are no intervening elements present.

It will be understood that, although the terms "first," "second," "third" etc. may be used herein to describe various elements, components, regions, layers and/or sections, these elements, components, regions, layers and/or sections should not be limited by these terms. These terms are only used to distinguish one element, component, region, layer or section from another element, component, region, layer or section. Thus, "a first element," "component," "region," "layer" or "section" discussed below could be termed a second element, component, region, layer or section without departing from the teachings herein.

The terminology used herein is for the purpose of describing particular embodiments only and is not intended to be limiting. As used herein, the singular forms "a," "an," and "the" are intended to include the plural forms, including "at least one," unless the content clearly indicates otherwise. "Or" means "and/or." As used herein, the term "and/or" includes any and all combinations of one or more of the associated listed items. It will be further understood that the terms "comprises" and/or "comprising," or "includes" and/or "including" when used in this specification, specify the presence of stated features, regions, integers, steps, operations, elements, and/or components, but do not preclude the presence or addition of one or more other features, regions, integers, steps, operations, elements, components, and/or groups thereof.

Furthermore, relative terms, such as "lower" or "bottom" and "upper" or "top," may be used herein to describe one element's relationship to another element as illustrated in the Figures. It will be understood that relative terms are intended to encompass different orientations of the device in addition to the orientation depicted in the Figures. For example, if the device in one of the figures is turned over, elements described as being on the "lower" side of other elements would then be oriented on "upper" sides of the other elements. The exemplary term "lower," may therefore, encompasses both an orientation of "lower" and "upper," depending on the particular orientation of the figure. Similarly, if the device in one of the figures is turned over, elements described as "below" or "beneath" other elements would then be oriented "above" the other elements. The exemplary terms "below" or "beneath" may, therefore, encompass both an orientation of above and below.

"About" or "approximately" as used herein is inclusive of the stated value and means within an acceptable range of deviation for the particular value as determined by one of ordinary skill in the art, considering the measurement in question and the error associated with measurement of the particular quantity (i.e., the limitations of the measurement system). The term such as "about" may mean within one or more standard deviations, or within ± 30%, 20%, 10%, 5% of the stated value, for example.

Unless otherwise defined, all terms (including technical and scientific terms) used herein have the same meaning as commonly understood by one of ordinary skill in the art to which this invention belongs. It will be further understood that terms, such as those defined in commonly used dictionaries, should be interpreted as having a meaning that is consistent with their meaning in the context of the relevant art and the present invention, and will not be interpreted in an idealized or overly formal sense unless expressly so defined herein.

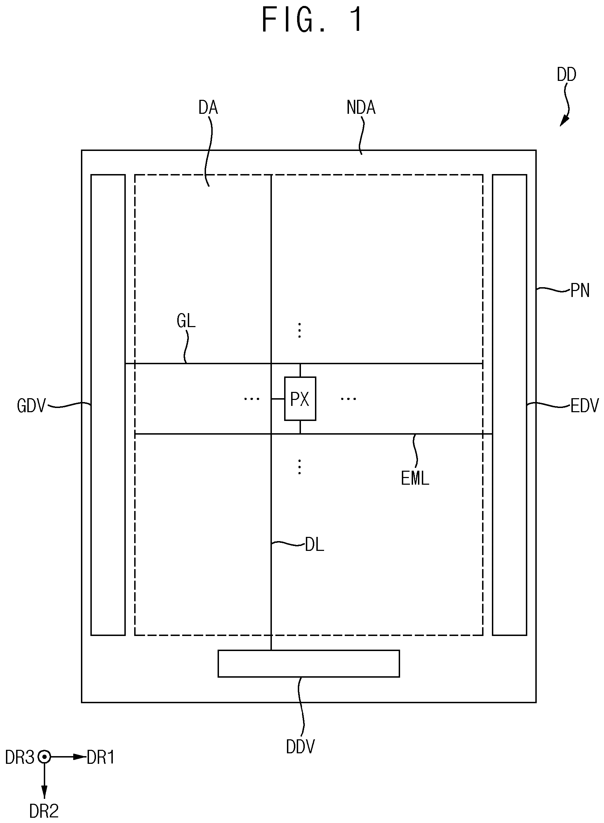

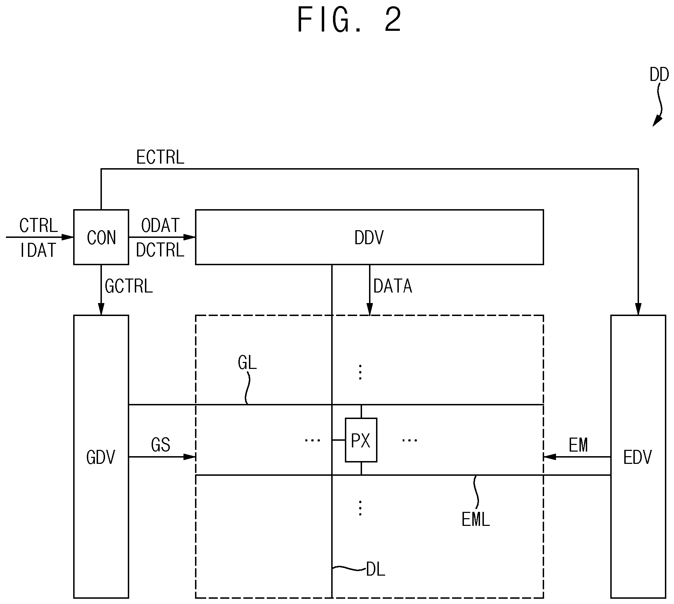

FIG. 1 is a plan view illustrating an embodiment of a display device according to the invention. FIG. 2 is a block diagram illustrating the display device of FIG. 1.

Referring to FIGS. 1 and 2, a display device DD may include a display panel PN and a driver for driving the display panel PN. The display panel PN may include a display area DA and a non-display area NDA.

The display area DA may be an area that displays an image. A plurality of pixels PX may be arranged in the display area DA. In an embodiment, the pixels PX may be repeatedly arranged along a first direction DR1 and a second direction DR2 intersecting the first direction DR1. Each of the pixels PX may emit light, so that the display area DA may display an image, for example. In an embodiment, the display area DA may display an image in a third direction DR3 intersecting each of the first direction DR1 and the second direction DR2, for example.

The non-display area NDA may be an area that does not display an image. The non-display area NDA may be disposed around the display area DA. In an embodiment, the non-display area NDA may surround the display area DA in a plan view, for example. The driver may be disposed in the non-display area NDA. In an embodiment, the driver may provide a signal and/or a voltage to the pixels PX, for example. In an embodiment, the driver may include a gate driver GDV, a light-emitting driver EDV, a data driver DDV, and a controller CON, for example.

Each of the pixels PX may be electrically connected to the gate driver GDV, the light-emitting driver EDV, and the data driver DDV. Specifically, each of the pixels PX may be connected to the gate driver GDV through a gate line GL, may be connected to the light-emitting driver EDV through a light-emitting line EML, and may be connected to the data driver DDV through a data line DL. Accordingly, each of the pixels PX may receive a gate signal GS, a light-emitting signal EM, and a data voltage DATA.

The gate driver GDV may receive a gate control signal GCTRL from the controller CON. The gate driver GDV may generate the gate signal GS based on the gate control signal GCTRL. The gate signal GS may be provided to each of the pixels PX through the gate line GL.

The light-emitting driver EDV may receive a light-emitting control signal ECTRL from the controller CON. The light-emitting driver EDV may generate the light-emitting signal EM based on the light-emitting control signal ECTRL. The light-emitting signal EM may be provided to each of the pixels PX through the light-emitting line EML.

The data driver DDV may receive a data control signal DCTRL and output image data ODAT from the controller CON. The data driver DDV may generate the data voltage DATA based on the data control signal DCTRL and the output image data ODAT. The data voltage DATA may be provided to each of the pixels PX through the data line DL.

The controller CON may receive a control signal CTRL and input image data IDAT from an external device. The controller CON may generate the gate control signal GCTRL, the light-emitting control signal ECTRL, the data control signal DCTRL, and the output image data ODAT based on the control signal CTRL and the input image data IDAT. The controller CON may control the gate driver GDV, the light-emitting driver EDV, and the data driver DDV.

Although FIG. 1 illustrates that the gate driver GDV is disposed on a first side of the display device DD and the light-emitting driver EDV is disposed on a second side of the display device DD, the invention is not limited thereto. In an embodiment, the gate driver GDV and the light-emitting driver EDV may be arranged together on the first side or the second side of the display device DD, for example. In another embodiment, the gate driver GDV and the light-emitting driver EDV may be unitary.

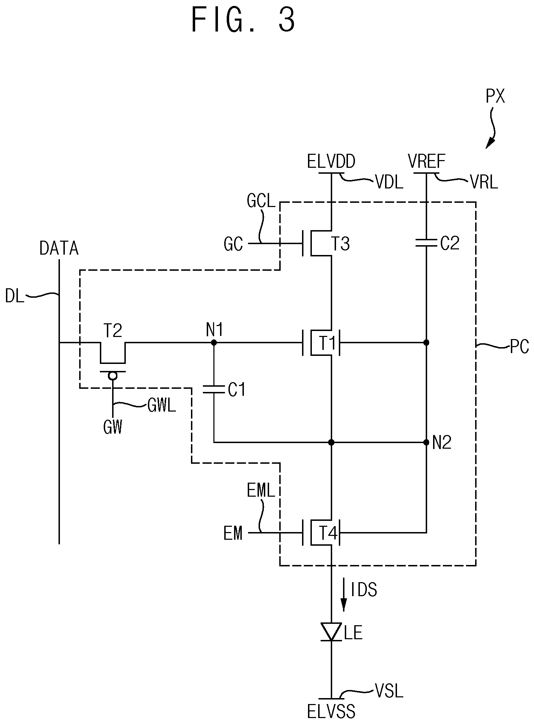

FIG. 3 is a circuit diagram illustrating an embodiment of a pixel included in the display device of FIG. 1.

Referring to FIG. 3, each of the pixels PX may include a pixel circuit PC and a light-emitting element LE. The pixel circuit PC may include at least one thin film transistor and at least one capacitor. In an embodiment, the pixel circuit PC may include a first transistor T1, a second transistor T2, a third transistor T3, a fourth transistor T4, a first capacitor C1, and a second capacitor C2.

The first transistor T1 may include a gate electrode connected to a first node N1, a first electrode (e.g., a source), and a second electrode (e.g., a drain). The first transistor T1 may further include a back gate electrode connected to a second node N2. The first transistor T1 may generate a driving current I_{DS} applied to the light-emitting element LE according to a voltage of the gate electrode of the first transistor T1 (i.e., the first node N1). In an embodiment, the first transistor T1 may be also referred to as a driving transistor. In an embodiment, the first transistor T1 may be an n-channel metal-oxide-semiconductor ("NMOS") transistor, for example, but the invention is not limited thereto.

The second transistor T2 may include a gate electrode connected to a first gate line GWL to receive a first gate signal GW, a first electrode (e.g., source) connected to the data line DL to receive the data voltage DATA, and a second electrode (e.g., drain) connected to the first node N1. When the second transistor T2 is turned on in response to the first gate signal GW, the data voltage DATA applied through the data line DL may be provided to the first node N1. In an embodiment, the second transistor T2 may be a p-channel metal-oxide-semiconductor ("PMOS") transistor, for example, but the invention is not limited thereto.

The third transistor T3 may include a gate electrode connected to a second gate line GCL to receive a second gate signal GC, a first electrode (e.g., a source) connected to a first power line VDL to receive a first power voltage (also referred to as a power voltage) ELVDD, and a second electrode (e.g., a drain) connected to the first electrode of the first transistor T1. The first power voltage ELVDD may be a high (i.e., a relatively high voltage level) power voltage. When the third transistor T3 is turned on in response to the second gate signal GC, the first power voltage ELVDD applied through the first power line VDL may be provided to the first transistor T1. In an embodiment, the third transistor T3 may be an NMOS transistor, for example, but the invention is not limited thereto.

The fourth transistor T4 may include a gate electrode connected to the light-emitting line EML to receive the light-emitting signal EM, a first electrode (e.g., source) connected to the second electrode of the first transistor T1, and a second electrode (e.g., drain) connected to the light-emitting element LE. The fourth transistor T4 may further include a back gate electrode connected to the second node N2. When the fourth transistor T4 is turned on in response to the light-emitting signal EM, the second electrode of the first transistor T1 and a first electrode (e.g., an anode) of the light-emitting element LE may be electrically connected to each other. Accordingly, the driving current I_{DS} generated from the first transistor T1 may be applied to the light-emitting element LE. In an embodiment, the fourth transistor T4 may be an NMOS transistor, for example, but the invention is not limited thereto.

The first capacitor C1 may include a first electrode connected to the first node N1 and a second electrode connected to the second node N2. The first capacitor C1 may serve to receive the data voltage DATA from the second transistor T2 and store the received data voltage DATA. In an embodiment, the first capacitor C1 may be also referred to as a storage capacitor, for example.

The second capacitor C2 may include a first electrode connected to a reference voltage line VRL to receive a reference voltage VREF and a second electrode connected to the second node N2. The second capacitor C2 may serve to hold a voltage of the second node N2 to have a constant voltage without being changed even when a peripheral signal changes. In an embodiment, the second electrode of the second capacitor C2 may be connected to the back gate electrode of the first transistor T1 and the back gate electrode of the fourth transistor T4 to improve characteristics of the first transistor T1 and the fourth transistor T4, for example. In an embodiment, the second capacitor C2 may be also referred to as a hold capacitor, for example.

The light-emitting element LE may include the first electrode connected to the second electrode of the fourth transistor T4 and a second electrode (e.g., a cathode) connected to a second power line VSL to receive a second power voltage ELVSS. The second power voltage ELVSS may be a low (i.e., a relatively low voltage level) power voltage. The second power voltage ELVSS may be a voltage of a lower level than the first power voltage ELVDD. The light-emitting element LE may emit light with a luminance corresponding to the driving current I_{DS} generated and applied from the first transistor T1.

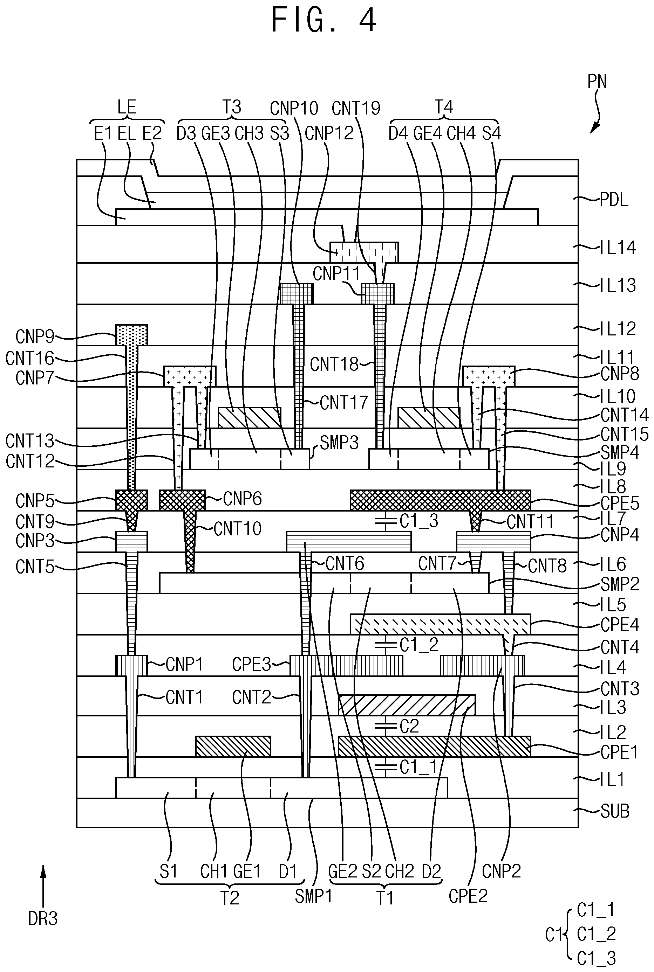

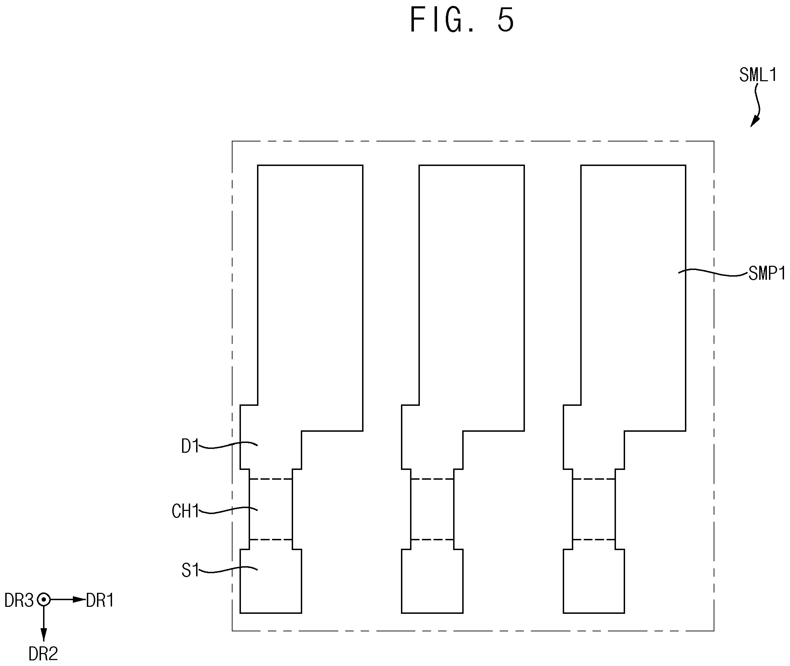

FIG. 4 is a cross-sectional view illustrating an embodiment of a display panel included in the display device of FIG. 1. FIGS. 5 to 31 are layout diagrams illustrating the display panel of FIG. 4.

In an embodiment, FIG. 4 may be a cross-sectional view schematically illustrating one pixel PX, and FIGS. 5 to 31 may be layout diagrams illustrating the pixels PX (e.g., three pixels PX arranged in the first direction DR1), for example. FIGS. 5 to 31 selectively illustrate some layers among a plurality of layers included in the display panel PN.

Hereinafter, an embodiment of an arrangement structure of transistors, capacitors, and lines included in each of the pixels PX will be described in more detail with reference to FIGS. 4 to 31. The arrangement structure of the pixels PX described with reference to FIGS. 4 to 31 may be repeated in the display panel PN.

Referring to FIGS. 4 to 31, the display panel PN may include a substrate SUB, a plurality of semiconductor layers, a plurality of conductive layers, a plurality of insulating layers, and the light-emitting element LE.

The display panel PN may include a first semiconductor layer (also referred to a second semiconductor layer based on an introduction order) SML1, a first insulating layer IL1, a first conductive layer CL1, a second insulating layer IL2, a second conductive layer CL2, a third insulating layer IL3, a third conductive layer CL3, a fourth insulating layer IL4, a fourth conductive layer CL4, a fifth insulating layer IL5, a second semiconductor layer (also referred to a first semiconductor layer based on an introduction order) SML2, a sixth insulating layer IL6, a fifth conductive layer CL5, a seventh insulating layer IL7, a sixth conductive layer CL6, an eighth insulating layer IL8, a third semiconductor layer SML3, a ninth insulating layer IL9, a seventh conductive layer CL7, a tenth insulating layer IL10, an eighth conductive layer CL8, an eleventh insulating layer IL11, a ninth conductive layer CL9, a twelfth insulating layer IL12, a tenth conductive layer CL10, a thirteenth insulating layer IL13, an eleventh conductive layer CL11, and a fourteenth insulating layer IL14 sequentially arranged along the third direction DR3 on the substrate SUB.

The substrate SUB may include a transparent or opaque material. The substrate SUB may include glass, quartz, plastic, or the like. These may be used alone or in any combinations with each other.

FIG. 5 illustrates the first semiconductor layer SML1. As illustrated in FIGS. 4 and 5, the first semiconductor layer SML1 may be disposed on the substrate SUB.

The first semiconductor layer SML1 may include a silicon semiconductor material or an oxide semiconductor material. In embodiments, the silicon semiconductor material may include amorphous silicon, polycrystalline silicon, or the like. In embodiments, the oxide semiconductor material may include indium gallium zinc oxide ("IGZO"), indium tin zinc oxide ("ITZO"), or the like. These may be used alone or in any combinations with each other.

The first semiconductor layer SML1 may include a first semiconductor pattern (also referred to a second semiconductor pattern based on an introduction order) SMP1. The first semiconductor pattern SMP1 may include a first source area (also referred to a second source area based on an introduction order) S1, a first drain area (also referred to a second drain area based on an introduction order) D1, and a first channel area (also referred to a second channel area based on an introduction order) CH1 between the first source area S1 and the first drain area D1. In an embodiment, the first drain area D1, the first channel area CH1, and the first source area S1 may be arranged along the second direction DR2, for example.

Electrical properties of the first semiconductor pattern SMP1 may vary depending on whether the first semiconductor pattern SMP1 is doped or not. In an embodiment, the first source area S1 and the first drain area D1 may be areas doped with P-type impurities or N-type impurities, for example.

In an embodiment, the first source area S1 may be the first electrode of the second transistor T2, the first drain area D1 may be the second electrode of the second transistor T2, and the first channel area CH1 may be a channel of the second transistor T2, for example.

The first insulating layer IL1 may be disposed on the first semiconductor layer SML1. The first insulating layer IL1 may include an inorganic insulating material such as silicon oxide (SiOₓ), silicon nitride (SiNₓ), silicon oxynitride (SiOₓN_{y}), or the like and/or an organic insulating material such as phenol resin, acrylic resin, polyimide resin, polyamide resin, siloxane resin, epoxy resin, or the like. The first insulating layer IL1 may have a single-layer structure or a multi-layer structure including a plurality of insulating layers. The first insulating layer IL1 may cover the first semiconductor pattern SMP1.

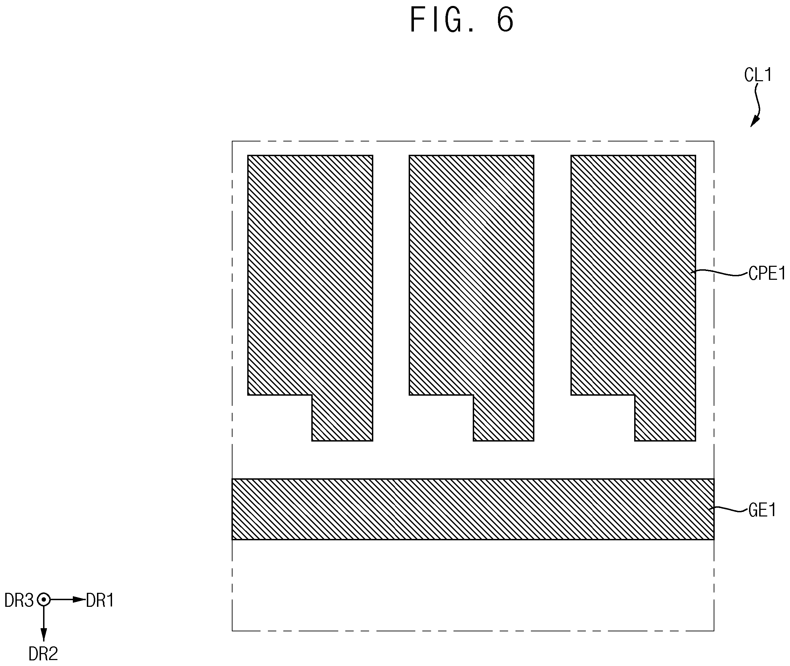

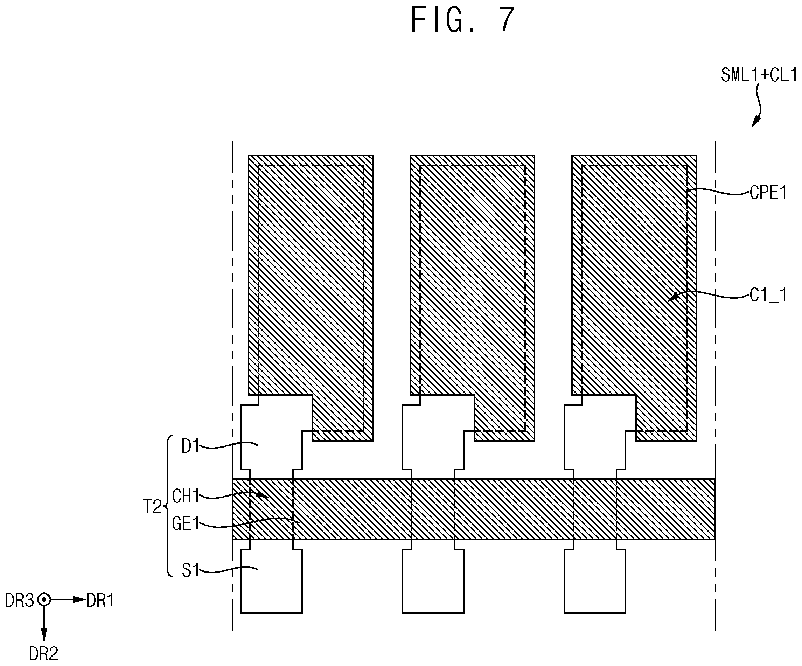

FIG. 6 illustrates the first conductive layer CL1, and FIG. 7 illustrates that the first conductive layer CL1 is further disposed in FIG. 5. As illustrated in FIGS. 4, 6, and 7, the first conductive layer CL1 may be disposed on the first insulating layer IL1.

The first conductive layer CL1 may include a conductive material such as a metal, an alloy, a conductive metal oxide, a conductive metal nitride, a transparent conductive material, or the like. The first conductive layer CL1 may have a single-layer structure or a multi-layer structure including a plurality of conductive layers.

The first conductive layer CL1 may include a first gate electrode GE1 and a first capacitor pattern CPE1. The first gate electrode GE1 and the first capacitor pattern CPE1 may be spaced apart from each other in a plan view. In an embodiment, the first gate electrode GE1 may be spaced apart from the first capacitor pattern CPE1 in the second direction DR2, for example.

In an embodiment, the first gate electrode GE1 may extend in the first direction DR1. The first gate electrode GE1 may at least partially overlap the first semiconductor pattern SMP1 in a plan view. A portion of the first gate electrode GE1 may overlap the first channel area CH1 of the first semiconductor pattern SMP1 in a plan view. The portion of the first gate electrode GE1 overlapping the first channel area CH1 in a plan view may be the gate electrode of the second transistor T2. The first gate signal GW of FIG. 3 may be applied to the first gate electrode GE1. In an embodiment, the first gate electrode GE1 may correspond to the first gate line GWL of FIG. 3, for example.

The first capacitor pattern CPE1 may at least partially overlap the first semiconductor pattern SMP1 in a plan view. A portion of the first capacitor pattern CPE1 may overlap the first drain area D1 of the first semiconductor pattern SMP1 in a plan view. In an embodiment, the first semiconductor pattern SMP1 and the portion of the first capacitor pattern CPE1 overlapping the first semiconductor pattern SMP1 in a plan view may define a first sub-capacitor C1_1. In an embodiment, the first semiconductor pattern SMP1 may be a first electrode of the first sub-capacitor, and the first capacitor pattern CPE1 may be a second electrode of the first sub-capacitor C1_1, for example. In an embodiment, the first sub-capacitor C1_1 may be a portion of the first capacitor C1.

The second insulating layer IL2 may be disposed on the first conductive layer CL1. The second insulating layer IL2 may include an inorganic insulating material and/or an organic insulating material. The second insulating layer IL2 may have a single-layer structure or a multi-layer structure including a plurality of insulating layers. The second insulating layer IL2 may cover the first gate electrode GE1 and the first capacitor pattern CPE1.

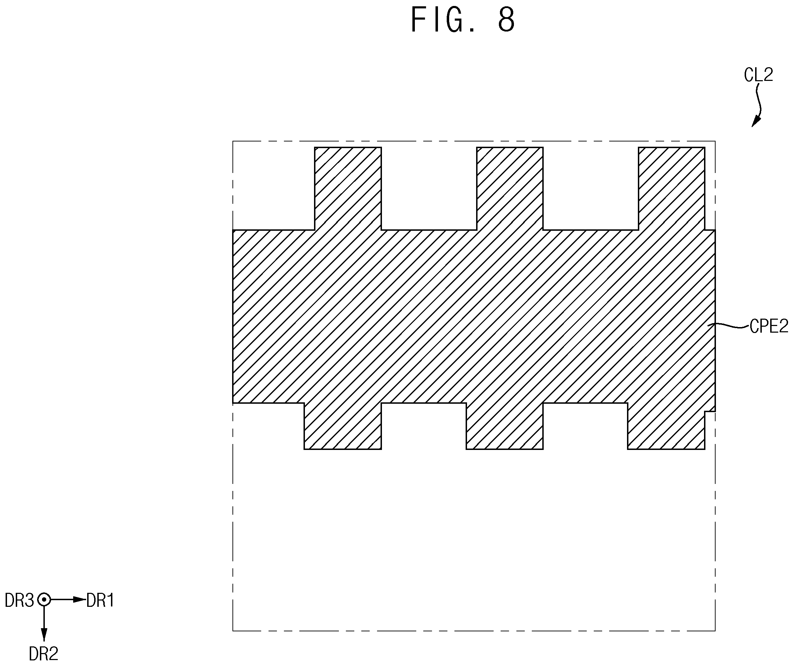

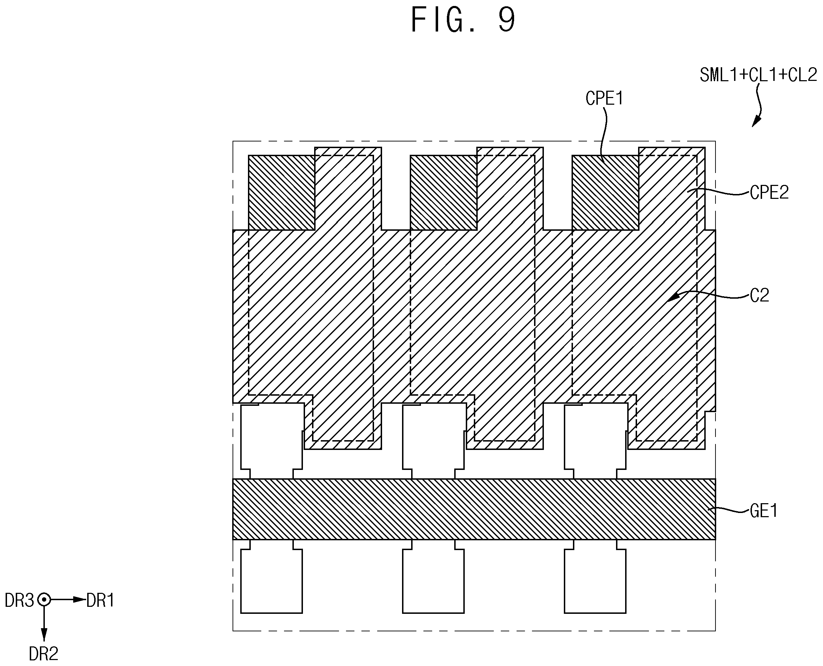

FIG. 8 illustrates the second conductive layer CL2, and FIG. 9 illustrates that the second conductive layer CL2 is further disposed in FIG. 7. As illustrated in FIGS. 4, 8, and 9, the second conductive layer CL2 may be disposed on the second insulating layer IL2.

The second conductive layer CL2 may include a conductive material. The second conductive layer CL2 may have a single-layer structure or a multi-layer structure including a plurality of conductive layers.

The second conductive layer CL2 may include a second capacitor pattern CPE2. In an embodiment, the second capacitor pattern CPE2 may extend in the first direction DR1. The second capacitor pattern CPE2 may at least partially overlap the first capacitor pattern CPE1 in a plan view. A portion of the second capacitor pattern CPE2 may overlap the first capacitor pattern CPE1 in a plan view. In an embodiment, the first capacitor pattern CPE1 and the portion of the second capacitor pattern CPE2 overlapping the first capacitor pattern CPE1 in a plan view may define the second capacitor C2. The second capacitor pattern CPE2 may be the first electrode of the second capacitor C2, and the first capacitor pattern CPE1 may be the second electrode of the second capacitor C2. The reference voltage VREF of FIG. 3 may be applied to the second capacitor pattern CPE2. In an embodiment, the second capacitor pattern CPE2 may correspond to the reference voltage line VRL, for example.

In addition, the second capacitor pattern CPE2 may at least partially overlap the first drain area D1 of the first semiconductor pattern SMP1 in a plan view. The first drain area D1 of the first semiconductor pattern SMP1 and the first and second capacitor patterns CPE1 and CPE2 may be arranged in the third direction DR3.

In an embodiment, the second capacitor C2 may at least partially overlap the first sub-capacitor C1_1 in a plan view. The first sub-capacitor C1_1 and the second capacitor C2 may be arranged in the third direction DR3.

The third insulating layer IL3 may be disposed on the second conductive layer CL2. The third insulating layer IL3 may include an inorganic insulating material and/or an organic insulating material. The third insulating layer IL3 may have a single-layer structure or a multi-layer structure including a plurality of insulating layers. The third insulating layer IL3 may cover the second capacitor pattern CPE2.

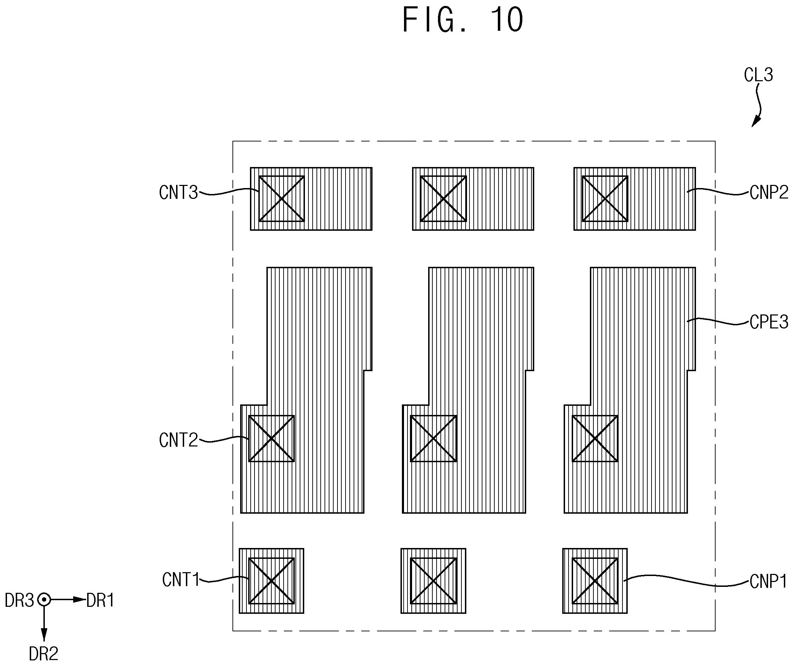

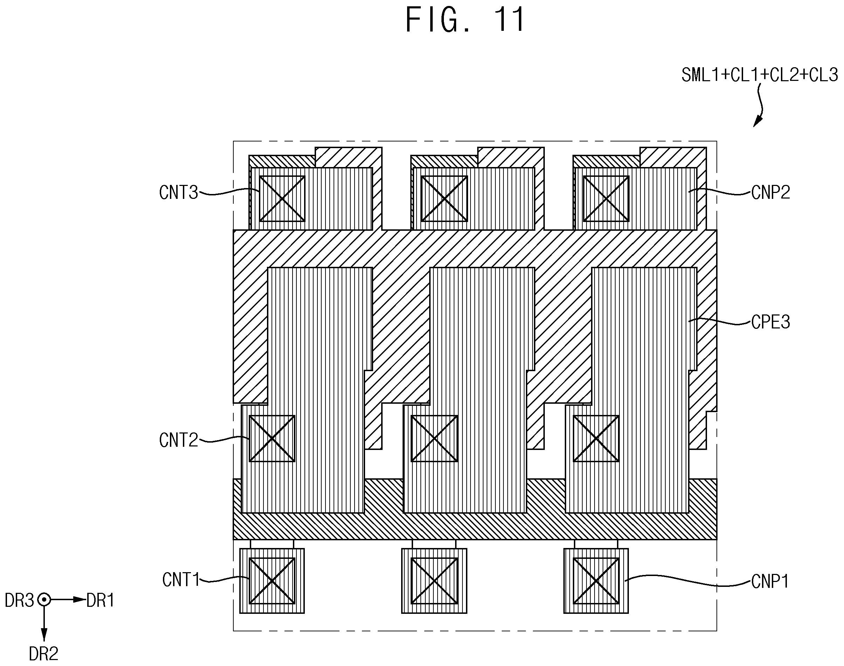

FIG. 10 illustrates the third conductive layer CL3, and FIG. 11 illustrates that the third conductive layer CL3 is further disposed in FIG. 9. As illustrated in FIGS. 4, 10, and 11, the third conductive layer CL3 may be disposed on the third insulating layer IL3.

The third conductive layer CL3 may include a conductive material. The third conductive layer CL3 may have a single-layer structure or a multi-layer structure including a plurality of conductive layers.

The third conductive layer CL3 may include a first connection pattern CNP1, a second connection pattern CNP2, and a third capacitor pattern CPE3. The first connection pattern CNP1, the second connection pattern CNP2, and the third capacitor pattern CPE3 may be spaced apart from each other in a plan view. In an embodiment, the third capacitor pattern CPE3 may be spaced apart from the second connection pattern CNP2 in the second direction DR2, and the first connection pattern CNP1 may be spaced apart from the third capacitor pattern CPE3 in the second direction DR2, for example. The second connection pattern CNP2, the third capacitor pattern CPE3, and the first connection pattern CNP1 may be arranged in the second direction DR2.

As illustrated in FIGS. 5, 9, and 11, the first connection pattern CNP1 may at least partially overlap the first source area S1 of the first semiconductor pattern SMP1 in a plan view. The first connection pattern CNP1 may be connected to the first source area S1 of the first semiconductor pattern SMP1 (i.e., the first electrode of the second transistor T2) through a first contact hole CNT1 penetrating a lower insulating layer (e.g., the first, second, and third insulating layers IL1, IL2, and IL3). In an embodiment, the first contact hole CNT1 may expose a portion of the first source area S1 of the first semiconductor pattern SMP1, and a portion of the first connection pattern CNP1 may contact the portion of the first source area S1 of the first semiconductor pattern SMP1 exposed by the first contact hole CNT1, for example.

As illustrated in FIGS. 5, 9, and 11, the third capacitor pattern CPE3 may at least partially overlap the first drain area D1 of the first semiconductor pattern SMP1 in a plan view. The third capacitor pattern CPE3 may be connected to the first drain area D1 of the first semiconductor pattern SMP1 (i.e., the second electrode of the second transistor T2) through a second contact hole CNT2 penetrating a lower insulating layer (e.g., the first, second, and third insulating layers IL1, IL2, and IL3). In an embodiment, the second contact hole CNT2 may expose a portion of the first drain area D1 of the first semiconductor pattern SMP1, and a portion of the third capacitor pattern CPE3 may contact the portion of the first drain area D1 of the first semiconductor pattern SMP1 exposed by the second contact hole CNT2, for example.

In addition, the third capacitor pattern CPE3 may at least partially overlap each of the first and second capacitor patterns CPE1 and CPE2 in a plan view. The first drain area D1 of the first semiconductor pattern SMP1 and the first, second, and third capacitor patterns CPE1, CPE2, and CPE3 may be arranged in the third direction DR3.

As illustrated in FIGS. 7, 9, and 11, the second connection pattern CNP2 may at least partially overlap the first capacitor pattern CPE1 in a plan view. The second connection pattern CNP2 may be connected to the first capacitor pattern CPE1 through a third contact hole CNT3 penetrating a lower insulating layer (e.g., the second and third insulating layers IL2 and IL3). In an embodiment, the third contact hole CNT3 may expose a portion of the first capacitor pattern CPE1, and a portion of the second connection pattern CNP2 may contact the portion of the first capacitor pattern CPE1 exposed by the third contact hole CNT3, for example.

The fourth insulating layer IL4 may be disposed on the third conductive layer CL3. The fourth insulating layer IL4 may include an inorganic insulating material and/or an organic insulating material. The fourth insulating layer IL4 may have a single-layer structure or a multi-layer structure including a plurality of insulating layers. The fourth insulating layer IL4 may cover the first connection pattern CNP1, the second connection pattern CNP2, and the third capacitor pattern CPE3.

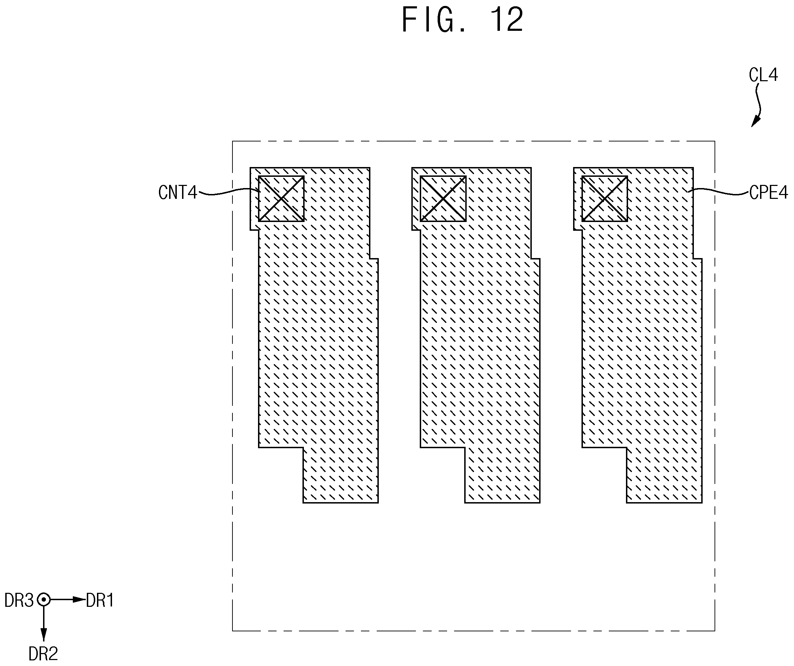

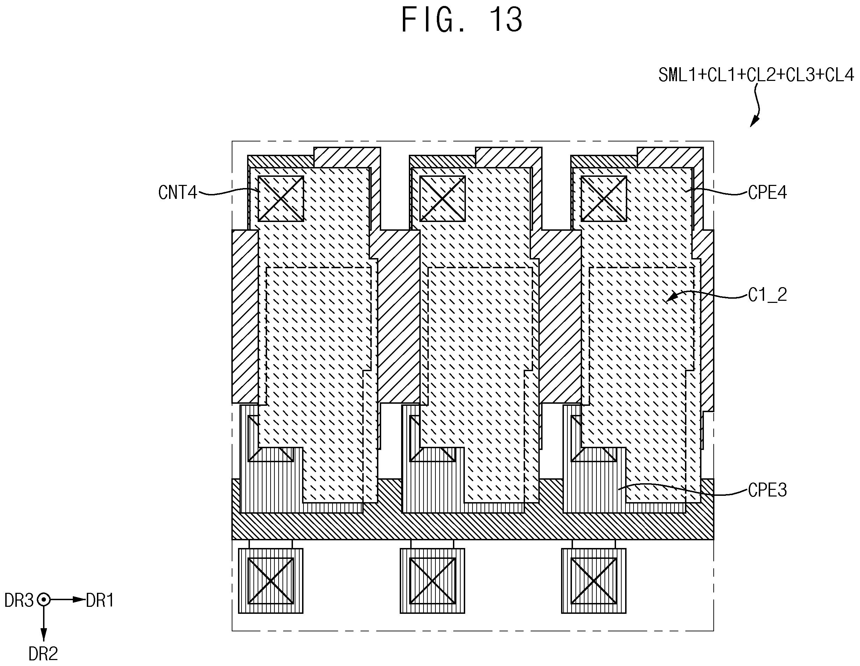

FIG. 12 illustrates the fourth conductive layer CL4, and FIG. 13 illustrates that the fourth conductive layer CL4 is further disposed in FIG. 11. As illustrated in FIGS. 4, 12, and 13, the fourth conductive layer CL4 may be disposed on the fourth insulating layer IL4.

The fourth conductive layer CL4 may include a conductive material. The fourth conductive layer CL4 may have a single-layer structure or a multi-layer structure including a plurality of conductive layers.

The fourth conductive layer CL4 may include a fourth capacitor pattern CPE4.

As illustrated in FIGS. 11 and 13, the fourth capacitor pattern CPE4 may at least partially overlap the second connection pattern CNP2 in a plan view. The fourth capacitor pattern CPE4 may be connected to the second connection pattern CNP2 through a fourth contact hole CNT4 penetrating a lower insulating layer (e.g., the fourth insulating layer IL4). In an embodiment, the fourth contact hole CNT4 may expose a portion of the second connection pattern CNP2, and a portion of the fourth capacitor pattern CPE4 may contact the portion of the second connection pattern CNP2 exposed by the fourth contact hole CNT4, for example.

Accordingly, the fourth capacitor pattern CPE4 may be connected to the first capacitor pattern CPE1 (i.e., the second electrode of the second capacitor C2) through the second connection pattern CNP2. In an embodiment, a portion of the fourth capacitor pattern CPE4 may be the back gate electrode of the first transistor T1, for example.

The fourth capacitor pattern CPE4 may at least partially overlap the third capacitor pattern CPE3 in a plan view. A portion of the fourth capacitor pattern CPE4 may overlap the third capacitor pattern CPE3 in a plan view. In an embodiment, the third capacitor pattern CPE3 and the portion of the fourth capacitor pattern CPE4 overlapping the third capacitor pattern CPE3 in a plan view may define a second sub-capacitor C1_2. In an embodiment, the third capacitor pattern CPE3 may be a first electrode of the second sub-capacitor C1_2, and the fourth capacitor pattern CPE4 may be a second electrode of the second sub-capacitor C1_2, for example. In an embodiment, the second sub-capacitor C1_2 may be a portion of the first capacitor C1.

In addition, the fourth capacitor pattern CPE4 may at least partially overlap each of the first drain area D1 of the first semiconductor pattern SMP1 and the first and second capacitor patterns CPE1 and CPE2 in a plan view. The first drain area D1 of the first semiconductor pattern SMP1 and the first, second, third, and fourth capacitor patterns CPE1, CPE2, CPE3, and CPE4 may be arranged in the third direction DR3.

In an embodiment, the second sub-capacitor C1_2 may at least partially overlap each of the first sub-capacitor C1_1 and the second capacitor C2 in a plan view. The first sub-capacitor C1_1, the second capacitor C2, and the second sub-capacitor C1_2 may be arranged in the third direction DR3.

The fifth insulating layer IL5 may be disposed on the fourth conductive layer CL4. The fifth insulating layer IL5 may include an inorganic insulating material and/or an organic insulating material. The fifth insulating layer IL5 may have a single-layer structure or a multi-layer structure including a plurality of insulating layers. The fifth insulating layer IL5 may cover the fourth capacitor pattern CPE4.

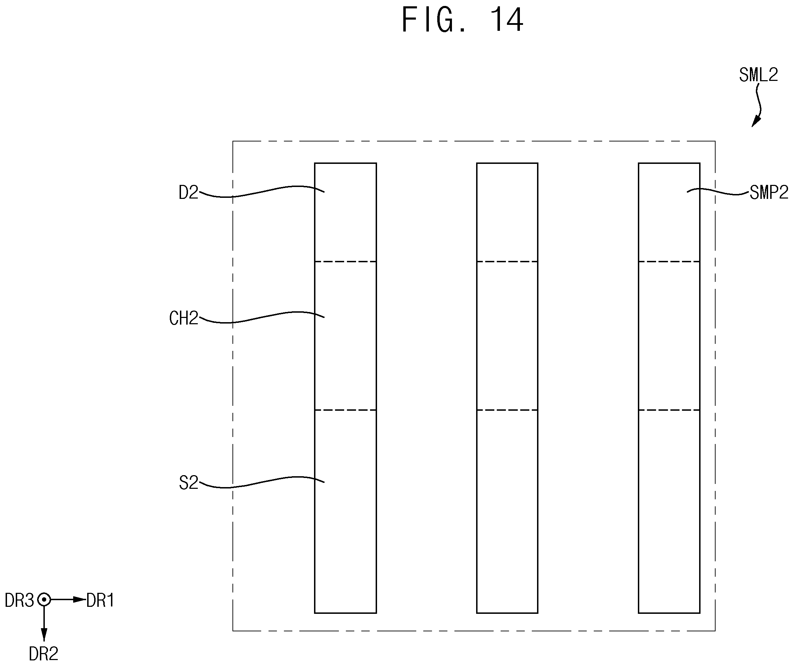

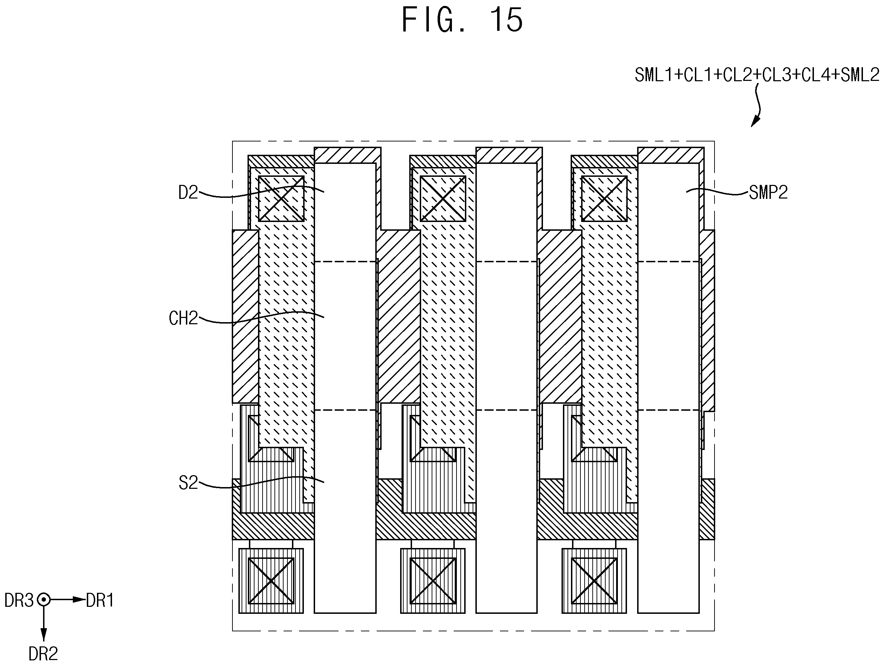

FIG. 14 illustrates the second semiconductor layer SML2, and FIG. 15 illustrates that the second semiconductor layer SML2 is further disposed in FIG. 13. As illustrated in FIGS. 4, 14, and 15, the second semiconductor layer SML2 may be disposed on the fifth insulating layer IL5. The first semiconductor layer SML1 may be disposed below the second semiconductor layer SML2.

In an embodiment, the second semiconductor layer SML2 may include an oxide semiconductor material. In embodiments, the oxide semiconductor material may include indium gallium zinc oxide, indium tin zinc oxide, or the like. These may be used alone or in any combinations with each other.

The second semiconductor layer SML2 may include a second semiconductor pattern (also referred to a first semiconductor pattern based on an introduction order) SMP2. The second semiconductor pattern SMP2 may include a second source area (also referred to a first source area based on an introduction order) S2, a second drain area (also referred to a first drain area based on an introduction order) D2, and a second channel area (also referred to a first channel area based on an introduction order) CH2 between the second source area S2 and the second drain area D2. In an embodiment, the second drain area D2, the second channel area CH2, and the second source area S2 may be arranged along the second direction DR2, for example.

Electrical properties of the second semiconductor pattern SMP2 may vary depending on whether the second semiconductor pattern SMP2 is doped or not. In an embodiment, the second source area S2 and the second drain area D2 may be areas doped with N-type impurities, but the invention is not limited thereto.

In an embodiment, the second source area S2 may be the first electrode of the first transistor T1, the second drain area D2 may be the second electrode of the first transistor T1, and the second channel area CH2 may be a channel of the first transistor T1, for example.

In an embodiment, the second semiconductor pattern SMP2 may at least partially overlap the first semiconductor pattern SMP1 in a plan view. In an embodiment, the second transistor T2 and the first transistor T1 may be arranged along the third direction DR3.

As illustrated in FIGS. 13 and 15, the second semiconductor pattern SMP2 may at least partially overlap the fourth capacitor pattern CPE4 in a plan view. A portion of the fourth capacitor pattern CPE4 may overlap the second channel area CH2 of the second semiconductor pattern SMP2 in a plan view. The portion of the fourth capacitor pattern CPE4 overlapping the second channel area CH2 in a plan view may be the back gate electrode of the first transistor T1.

The sixth insulating layer IL6 may be disposed on the second semiconductor layer SML2. The sixth insulating layer IL6 may include an inorganic insulating material and/or an organic insulating material. The sixth insulating layer IL6 may have a single-layer structure or a multi-layer structure including a plurality of insulating layers. The sixth insulating layer IL6 may cover the second semiconductor pattern SMP2.

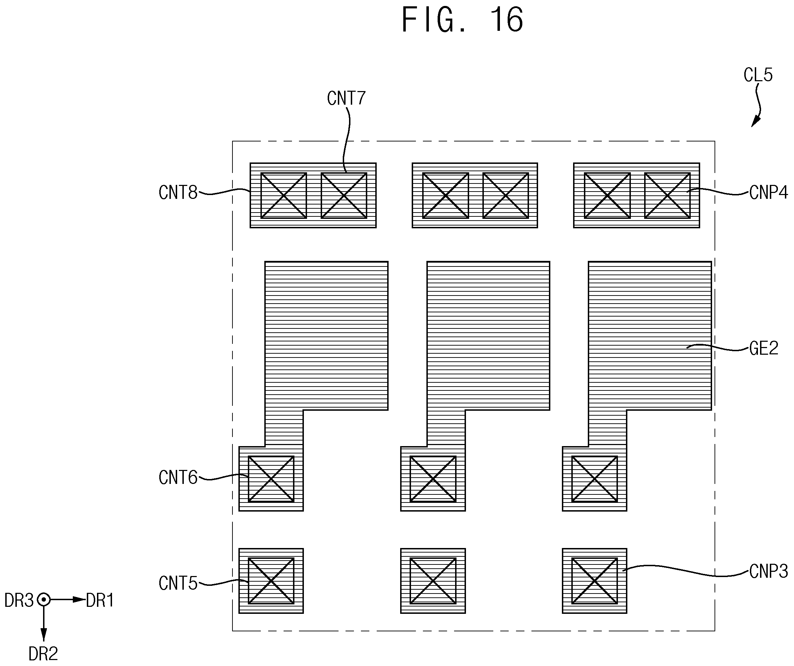

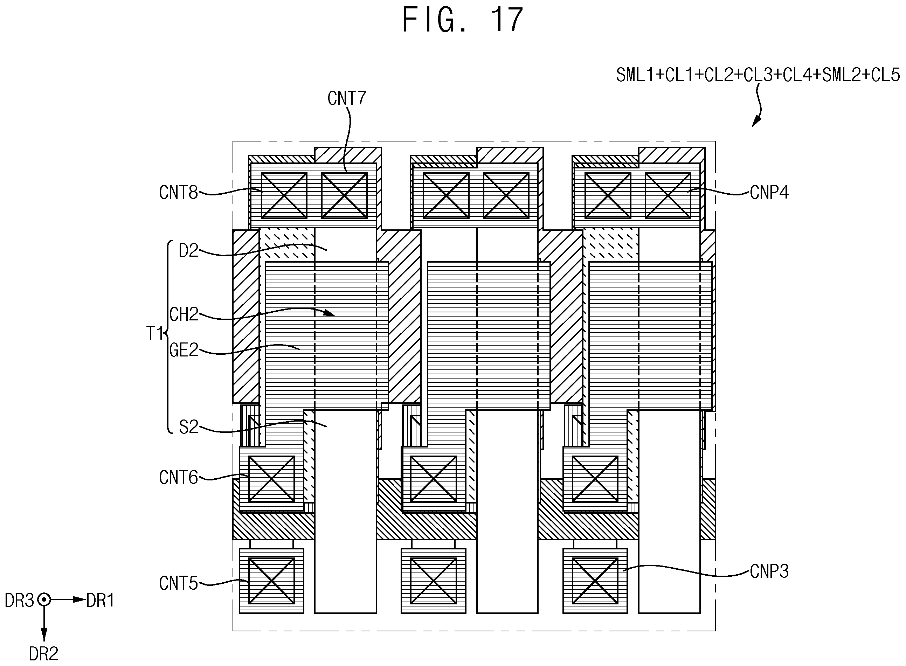

FIG. 16 illustrates the fifth conductive layer CL5, and FIG. 17 illustrates that the fifth conductive layer CL5 is further disposed in FIG. 15. As illustrated in FIGS. 4, 16, and 17, the fifth conductive layer CL5 may be disposed on the sixth insulating layer IL6.

The fifth conductive layer CL5 may include a conductive material. The fifth conductive layer CL5 may have a single-layer structure or a multi-layer structure including a plurality of conductive layers.

The fifth conductive layer CL5 may include a third connection pattern CNP3, a fourth connection pattern CNP4, and a second gate electrode GE2. The third connection pattern CNP3, the fourth connection pattern CNP4, and the second gate electrode GE2 may be spaced apart from each other in a plan view. In an embodiment, the second gate electrode GE2 may be spaced apart from the fourth connection pattern CNP4 in the second direction DR2, and the third connection pattern CNP3 may be spaced apart from the second gate electrode GE2 in the second direction DR2, for example. The fourth connection pattern CNP4, the second gate electrode GE2, and the third connection pattern CNP3 may be arranged in the second direction DR2.

As illustrated in FIGS. 11, 15, and 17, the third connection pattern CNP3 may at least partially overlap the first connection pattern CNP1 in a plan view. The third connection pattern CNP3 may be connected to the first connection pattern CNP1 through a fifth contact hole CNT5 penetrating a lower insulating layer (e.g., the fourth, fifth, and sixth insulating layers IL4, IL5, and IL6). In an embodiment, the fifth contact hole CNT5 may expose a portion of the first connection pattern CNP1, and a portion of the third connection pattern CNP3 may contact the portion of the first connection pattern CNP1 exposed by the fifth contact hole CNT5, for example.

As illustrated in FIGS. 11, 15, and 17, the second gate electrode GE2 may at least partially overlap the third capacitor pattern CPE3 in a plan view. The second gate electrode GE2 may be connected to the third capacitor pattern CPE3 through a sixth contact hole CNT6 penetrating a lower insulating layer (e.g., the fourth, fifth, and sixth insulating layers IL4, IL5, and IL6). In an embodiment, the sixth contact hole CNT6 may expose a portion of the third capacitor pattern CPE3, and a portion of the second gate electrode GE2 may contact the portion of the third capacitor pattern CPE3 exposed by the sixth contact hole CNT6, for example.

The second gate electrode GE2 may at least partially overlap the second semiconductor pattern SMP2 in a plan view. A portion of the second gate electrode GE2 may overlap the second channel area CH2 of the second semiconductor pattern SMP2 in a plan view. The portion of the second gate electrode GE2 overlapping the second channel area CH2 in a plan view may be the gate electrode of the first transistor T1.

Accordingly, the portion of the second gate electrode GE2 (i.e., the gate electrode of the first transistor T1) may be connected to the first drain area D1 of the first semiconductor pattern SMP1 (i.e., the second electrode of the second transistor T2) through the third capacitor pattern CPE3.

In addition, the second gate electrode GE2 may at least partially overlap each of the first drain area D1 of the first semiconductor pattern SMP1 and the first, second, third, and fourth capacitor patterns CPE1, CPE2, CPE3, and CPE4 in a plan view. The first drain area D1 of the first semiconductor pattern SMP1, the first, second, third, and fourth capacitor patterns CPE1, CPE2, CPE3, and CPE4 and the second gate electrode GE2 may be arranged in the third direction DR3.

As illustrated in FIGS. 13, 15, and 17, the fourth connection pattern CNP4 may at least partially overlap each of the second drain area D2 of the second semiconductor pattern SMP2 and the fourth capacitor pattern CPE4 in a plan view.

The fourth connection pattern CNP4 may be connected to the second drain area D2 of the second semiconductor pattern SMP2 (i.e., the second electrode of the first transistor T1) through a seventh contact hole CNT7 penetrating a lower insulating layer (e.g., the sixth insulating layer IL6). In an embodiment, the seventh contact hole CNT7 may expose a portion of the second drain area D2 of the second semiconductor pattern SMP2, and a portion of the fourth connection pattern CNP4 may contact the portion of the second drain area D2 of the second semiconductor pattern SMP2 exposed by the seventh contact hole CNT7, for example.

In addition, the fourth connection pattern CNP4 may be connected to the fourth capacitor pattern CPE4 through an eighth contact hole CNT8 penetrating a lower insulating layer (e.g., the fifth and sixth insulating layers IL5 and IL6). In an embodiment, the eighth contact hole CNT8 may expose a portion of the fourth capacitor pattern CPE4, and a portion of the fourth connection pattern CNP4 may contact the portion of the fourth capacitor pattern CPE4 exposed by the eighth contact hole CNT8, for example.

Accordingly, the fourth connection pattern CNP4 may electrically connect the second drain area D2 of the second semiconductor pattern SMP2 (i.e., the second electrode of the first transistor T1) and the fourth capacitor pattern CPE4. That is, the second drain area D2 of the second semiconductor pattern SMP2 may be connected to the fourth capacitor pattern CPE4 through the fourth connection pattern CNP4, and may be connected to the first capacitor pattern CPE1 (i.e., the second electrode of the second capacitor C2) through the fourth connection pattern CNP4, the fourth capacitor pattern CPE4, and the second connection pattern CNP2.

The seventh insulating layer IL7 may be disposed on the fifth conductive layer CL5. The seventh insulating layer IL7 may include an inorganic insulating material and/or an organic insulating material. The seventh insulating layer IL7 may have a single-layer structure or a multi-layer structure including a plurality of insulating layers. The seventh insulating layer IL7 may cover the third connection pattern CNP3, the fourth connection pattern CNP4, and the second gate electrode GE2.

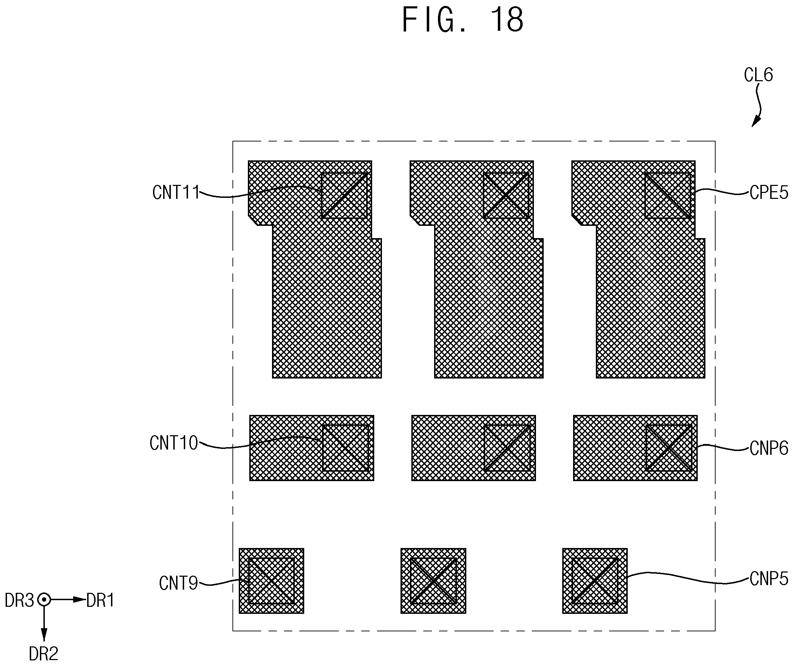

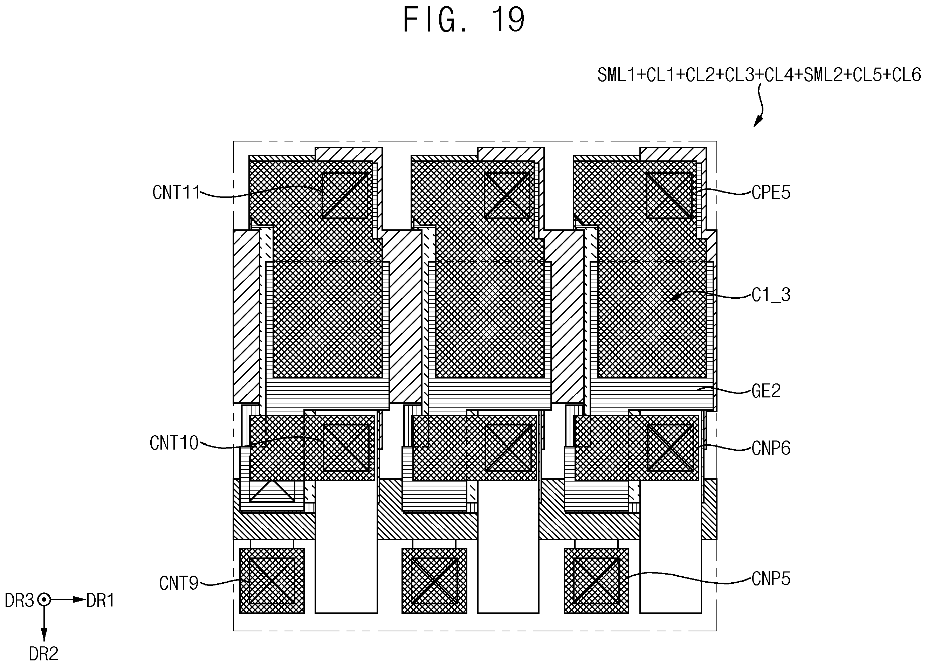

FIG. 18 illustrates the sixth conductive layer CL6, and FIG. 19 illustrates that the sixth conductive layer CL6 is further disposed in FIG. 17. As illustrated in FIGS. 4, 18, and 19, the sixth conductive layer CL6 may be disposed on the seventh insulating layer IL7.

The sixth conductive layer CL6 may include a conductive material. The sixth conductive layer CL6 may have a single-layer structure or a multi-layer structure including a plurality of conductive layers.

The sixth conductive layer CL6 may include a fifth connection pattern CNP5, a sixth connection pattern CNP6, and a fifth capacitor pattern CPE5. The fifth connection pattern CNP5, the sixth connection pattern CNP6, and the fifth capacitor pattern CPE5 may be spaced apart from each other in a plan view. In an embodiment, the sixth connection pattern CNP6 may be spaced apart from the fifth capacitor pattern CPE5 in the second direction DR2, and the fifth connection pattern CNP5 may be spaced apart from the sixth connection pattern CNP6 in the second direction DR2, for example. The fifth capacitor pattern CPE5, the sixth connection pattern CNP6, and the fifth connection pattern CNP5 may be arranged in the second direction DR2.

As illustrated in FIGS. 17 and 19, the fifth connection pattern CNP5 may at least partially overlap the third connection pattern CNP3 in a plan view. The fifth connection pattern CNP5 may be connected to the third connection pattern CNP3 through a ninth contact hole CNT9 penetrating a lower insulating layer (e.g., the seventh insulating layer IL7). In an embodiment, the ninth contact hole CNT9 may expose a portion of the third connection pattern CNP3, and a portion of the fifth connection pattern CNP5 may contact the portion of the third connection pattern CNP3 exposed by the ninth contact hole CNT9, for example.

As illustrated in FIGS. 15, 17, and 19, the sixth connection pattern CNP6 may at least partially overlap the second source area S2 of the second semiconductor pattern SMP2 in a plan view. The sixth connection pattern CNP6 may be connected to the second source area of the second semiconductor pattern SMP2 (i.e., the first electrode of the first transistor T1) through a tenth contact hole CNT10 penetrating a lower insulating layer (e.g., the sixth and seventh insulating layers IL6 and IL7). In an embodiment, the tenth contact hole CNT10 may expose a portion of the second source area S2 of the second semiconductor pattern SMP2, and a portion of the sixth connection pattern CNP6 may contact the portion of the second source area S2 of the second semiconductor pattern SMP2 exposed by the tenth contact hole CNT10, for example.

As illustrated in FIGS. 17 and 19, the fifth capacitor pattern CPE5 may at least partially overlap the fourth connection pattern CNP4 in a plan view. The fifth capacitor pattern CPE5 may be connected to the fourth connection pattern CNP4 through an eleventh contact hole CNT11 penetrating a lower insulating layer (e.g., the seventh insulating layer IL7). In an embodiment, the eleventh contact hole CNT11 may expose a portion of the fourth connection pattern CNP4, and a portion of the fifth capacitor pattern CPE5 may contact the portion of the fourth connection pattern CNP4 exposed by the eleventh contact hole CNT11, for example.

Accordingly, the fifth capacitor pattern CPE5 may be connected to the second drain area D2 of the second semiconductor pattern SMP2 (i.e., the second electrode of the first transistor T1) through the fourth connection pattern CNP4, may be connected to the first capacitor pattern CPE1 (i.e., the second electrode of the second capacitor C2) through the fourth connection pattern CNP4, the fourth capacitor pattern CPE4, and the second connection pattern CNP2. In an embodiment, a portion of the fifth capacitor pattern CPE5 may be the back gate electrode of the fourth transistor T4, for example.

The fifth capacitor pattern CPE5 may at least partially overlap the second gate electrode GE2 in a plan view. A portion of the fifth capacitor pattern CPE5 may overlap the second gate electrode GE2 in a plan view. In an embodiment, the second gate electrode GE2 and the portion of the fifth capacitor pattern CPE5 overlapping the second gate electrode GE2 in a plan view may define a third sub-capacitor C1_3. In an embodiment, the second gate electrode GE2 may be a first electrode of the third sub-capacitor C1_3, and the fifth capacitor pattern CPE5 may be a second electrode of the third sub-capacitor C1_3, for example. In an embodiment, the third sub-capacitor C1_3 may be a portion of the first capacitor C1.

In addition, the fifth capacitor pattern CPE5 may at least partially overlap each of the first drain area D1 of the first semiconductor pattern SMP1 and the first, second, third, and fourth capacitor patterns CPE1, CPE2, CPE3, and CPE4 in a plan view. The first drain area D1 of the first semiconductor pattern SMP1, the first, second, third, and fourth capacitor patterns CPE1, CPE2, CPE3, and CPE4, the second gate electrode GE2, and the fifth capacitor pattern CPE5 may be arranged in the third direction DR3.

In an embodiment, the third sub-capacitor C1_3 may at least partially overlap each of the first and second sub-capacitors C1_1 and C1_2 and the second capacitor C2 in a plan view. The first sub-capacitor C1_1, the second capacitor C2, the second sub-capacitor C1_2, and the third sub-capacitor C1_3 may be arranged in the third direction DR3.

In an embodiment, the first capacitor C1 may include the first sub-capacitor C1_1, the second sub-capacitor C1_2, and the third sub-capacitor C1_3. The first, second, and third sub-capacitors C1_1, C1_2, and C1_3 may be defined in different layers, and may overlap each other in a plan view. That is, the first capacitor C1 may have a multi-capacitor (e.g., triple-capacitor) structure, and the first, second, and third sub-capacitors C1_1, C1_2, and C1_3 may function as one capacitor.

In an embodiment, the first semiconductor pattern SMP1 of the first semiconductor layer SML1 and the first capacitor pattern CPE1 of the first conductive layer CL1 may define the first sub-capacitor C1_1, the third capacitor pattern CPE3 of the third conductive layer CL3 and the fourth capacitor pattern CPE4 of the fourth conductive layer CL4 may define the second sub-capacitor C1_2, and the second gate electrode GE2 of the fifth conductive layer CL5 and the fifth capacitor pattern CPE5 of the sixth conductive layer CL6 may define the third sub-capacitor C1_3, for example. Accordingly, a capacitance of the first capacitor C1 may be secured even within a limited area. That is, the capacitance of the first capacitor C1 may be further increased while further reducing the area occupied by the first capacitor C1.

In addition, in an embodiment, the second capacitor C2 may be defined in a different layer from the first capacitor C1 (i.e., each of the first, second, and third sub-capacitors C1_1, C1_2, and C1_3), and may overlap the first capacitor C1 (i.e., each of the first, second, and third sub-capacitors C1_1, C1_2, and C1_3) in a plan view. In an embodiment, the first capacitor pattern CPE1 of the first conductive layer CL1 and the second capacitor pattern CPE2 of the second conductive layer CL2 may define the second capacitor C2, for example. Accordingly, degree of integration of the pixel circuits PC included in the display panel PN may be improved, and resolution of the display device DD may be improved.

In an embodiment, a thickness of each of the insulating layers defining the first, second, and third sub-capacitors C1_1, C1_2, and C1_3 and the second capacitor C2 may be greater than or equal to about 50 nanometer (nm) (500 angstroms (Å)) and less than or equal to about 400 nm (4000 Å). When the thickness of each of the insulating layers is less than about 50 nm (500 Å), static electricity may be generated between the conductive layers and/or the semiconductor layers with the insulating layers interposed therebetween, and when the thickness of each of the insulating layers is greater than about 400 nm (4000 Å), it may be relatively difficult to secure the capacitance of the capacitor.

In an embodiment, a length of the first insulating layer IL1 in a thickness direction (i.e., the third direction DR3) between the first semiconductor pattern SMP1 and the first capacitor pattern CPE1 defining the first sub-capacitor C1_1 may be greater than or equal to about 50 nm (500 Å) and less than or equal to about 400 nm (4000 Å), for example. In an embodiment, a length of the fourth insulating layer IL4 in a thickness direction (i.e., the third direction DR3) between the third capacitor pattern CPE3 and the fourth capacitor pattern CPE4 defining the second sub-capacitor C1_2 may be greater than or equal to about 50 nm (500 Å) and less than or equal to about 400 nm (4000 Å), for example. In an embodiment, a length of the seventh insulating layer IL7 in a thickness direction (i.e., the third direction DR3) between the second gate electrode GE2 and the fifth capacitor pattern CPE5 defining the third sub-capacitor C1_3 may be greater than or equal to about 50 nm (500 Å) and less than or equal to about 400 nm (4000 Å), for example. In an embodiment, a length of the second insulating layer IL2 between the first capacitor pattern CPE1 and the second capacitor pattern CPE2 defining the second capacitor C2 in a thickness direction (i.e., the third direction DR3) may be greater than or equal to about 50 nm (500 Å) and less than or equal to about 400 nm (4000 Å), for example.

The eighth insulating layer IL8 may be disposed on the sixth conductive layer CL6. The eighth insulating layer IL8 may include an inorganic insulating material and/or an organic insulating material. The eighth insulating layer IL8 may have a single-layer structure or a multi-layer structure including a plurality of insulating layers. The eighth insulating layer IL8 may cover the fifth connection pattern CNP5, the sixth connection pattern CNP6, and the fifth capacitor pattern CPE5.

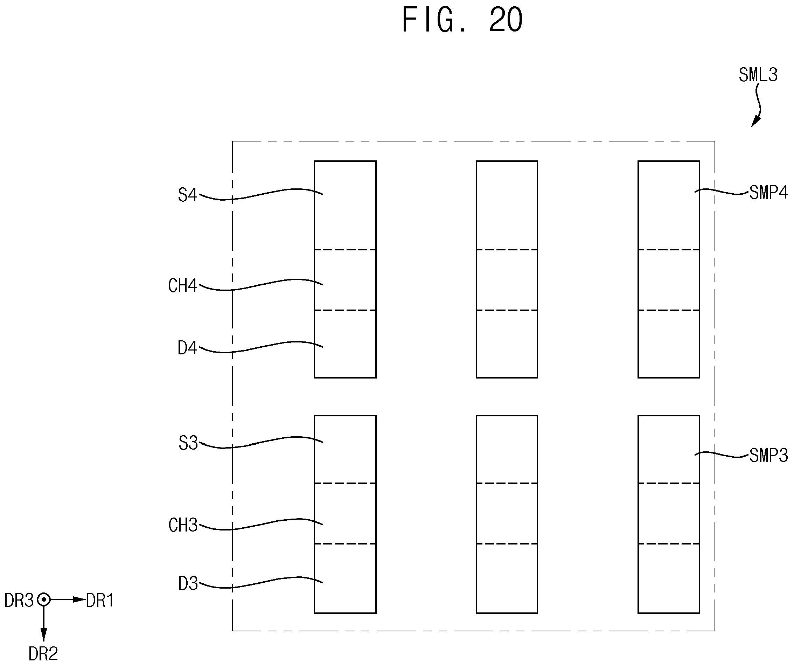

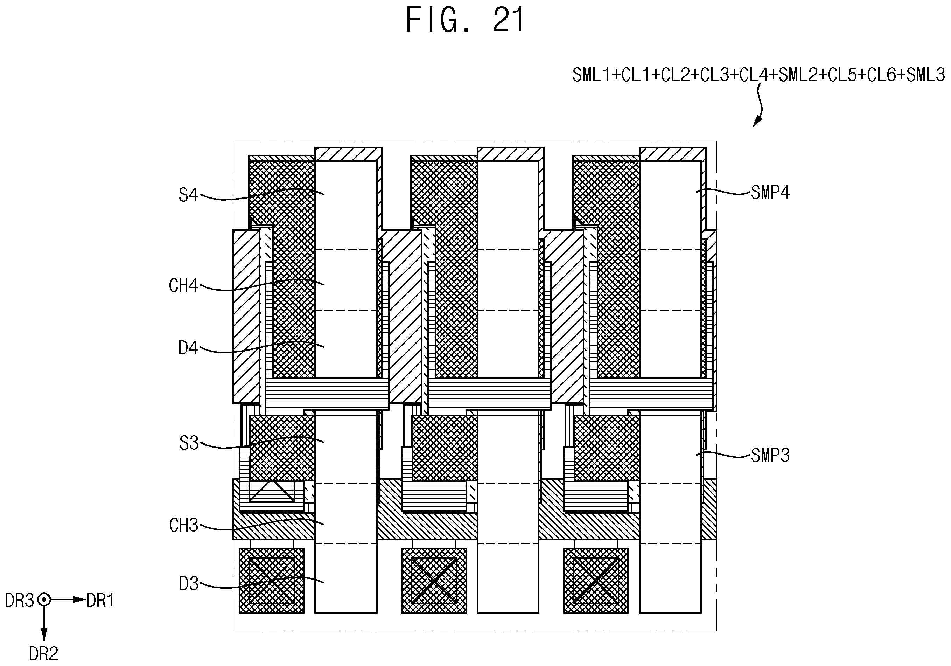

FIG. 20 illustrates the third semiconductor layer SML3, and FIG. 21 illustrates that the third semiconductor layer SML3 is further disposed in FIG. 19. As illustrated in FIGS. 4, 20, and 21, the third semiconductor layer SML3 may be disposed on the eighth insulating layer IL8. The third semiconductor layer SML3 may be disposed on the second semiconductor layer SML2. The second semiconductor layer SML2 may be disposed between the first semiconductor layer SML1 and the third semiconductor layer SML3.

The third semiconductor layer SML3 may include a silicon semiconductor material or an oxide semiconductor material. In embodiments, the silicon semiconductor material may include amorphous silicon, polycrystalline silicon, or the like. In embodiments, the oxide semiconductor material may include indium gallium zinc oxide, indium tin zinc oxide, or the like. These may be used alone or in any combinations with each other.

The second semiconductor layer SML2 may include a third semiconductor pattern SMP3 and a fourth semiconductor pattern SMP4. The third semiconductor pattern SMP3 and the fourth semiconductor pattern SMP4 may be spaced apart from each other in a plan view. In an embodiment, the third semiconductor pattern SMP3 may be spaced apart from the fourth semiconductor pattern SMP4 in the second direction DR2, for example.

The third semiconductor pattern SMP3 may include a third source area S3, a third drain area D3, and a third channel area CH3 between the third source area S3 and the third drain area D3. In an embodiment, the third source area S3, the third channel area CH3, and the third drain area D3 may be arranged along the second direction DR2. Electrical properties of the third semiconductor pattern SMP3 may vary depending on whether the third semiconductor pattern SMP3 is doped or not, for example. In an embodiment, the third source area S3 and the third drain area D3 may be areas doped with N-type impurities or P-type impurities, for example.

In an embodiment, the third source area S3 may be the first electrode of the third transistor T3, the third drain area D3 may be the second electrode of the third transistor T3, and the third channel area CH3 may be a channel of the third transistor T3, for example.

In an embodiment, the third semiconductor pattern SMP3 may at least partially overlap each of the first and second semiconductor patterns SMP1 and SMP2 in a plan view. In an embodiment, the second transistor T2, the first transistor T1, and the third transistor T3 may be sequentially arranged along the third direction DR3. That is, the pixel circuit PC included in the display panel PN may be implemented as a multi-layer structure in which the first, second, and third transistors T1, T2, and T3 are stacked in the third direction DR3, and accordingly, the degree of integration of the pixel circuits PC may be improved.

The fourth semiconductor pattern SMP4 may include a fourth source area S4, a fourth drain area D4, and a fourth channel area CH4 between the fourth source area S4 and the fourth drain area D4. In an embodiment, the fourth source area S4, the fourth channel area CH4, and the fourth drain area D4 may be arranged along the second direction DR2, for example. Electrical properties of the fourth semiconductor pattern SMP4 may vary depending on whether the fourth semiconductor pattern SMP4 is doped or not. In an embodiment, the fourth source area S4 and the fourth drain area D4 may be areas doped with N-type impurities or P-type impurities, for example.

In an embodiment, the fourth source area S4 may be the first electrode of the fourth transistor T4, the fourth drain area D4 may be the second electrode of the fourth transistor T4, and the fourth channel area CH4 may be a channel of the fourth transistor T4, for example.

In an embodiment, the fourth semiconductor pattern SMP4 may at least partially overlap each of the first and second semiconductor patterns SMP1 and SMP2 in a plan view. In an embodiment, the second transistor T2, the first transistor T1, and the fourth transistor T4 may be sequentially arranged along the third direction DR3. That is, the pixel circuit PC included in the display panel PN may be implemented as a multi-layer structure in which the first, second, and fourth transistors T1, T2, and T4 are stacked in the third direction DR3, and accordingly, the degree of integration of the pixel circuits PC may be improved.

As illustrated in FIGS. 19 and 21, the fourth semiconductor pattern SMP4 may at least partially overlap the fifth capacitor pattern CPE5 in a plan view. A portion of the fifth capacitor pattern CPE5 may overlap the fourth channel area CH4 of the fourth semiconductor pattern SMP4 in a plan view. The portion of the fifth capacitor pattern CPE5 overlapping the fourth channel area CH4 in a plan view may be the back gate electrode of the fourth transistor T4.

The ninth insulating layer IL9 may be disposed on the third semiconductor layer SML3. The ninth insulating layer IL9 may include an inorganic insulating material and/or an organic insulating material. The ninth insulating layer IL9 may have a single-layer structure or a multi-layer structure including a plurality of insulating layers. The ninth insulating layer IL9 may cover the third semiconductor pattern SMP3 and the fourth semiconductor pattern SMP4.

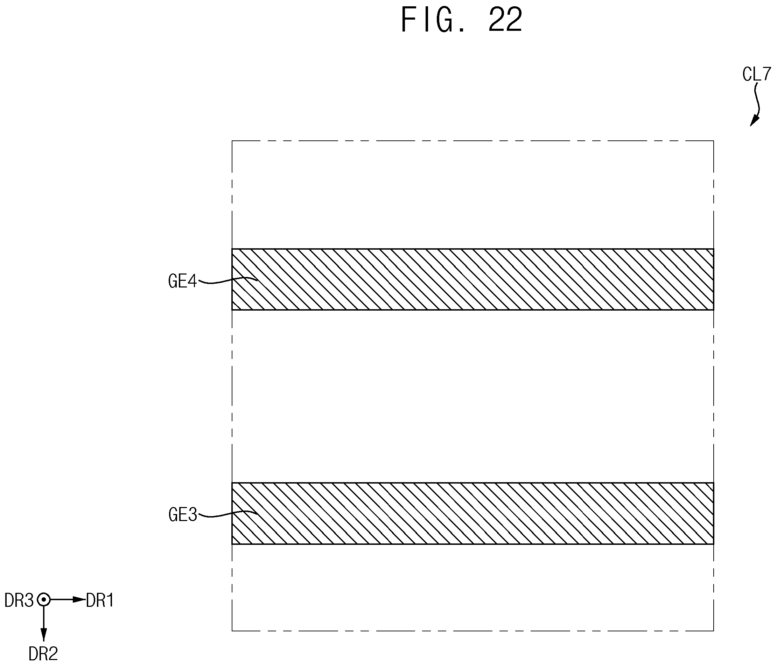

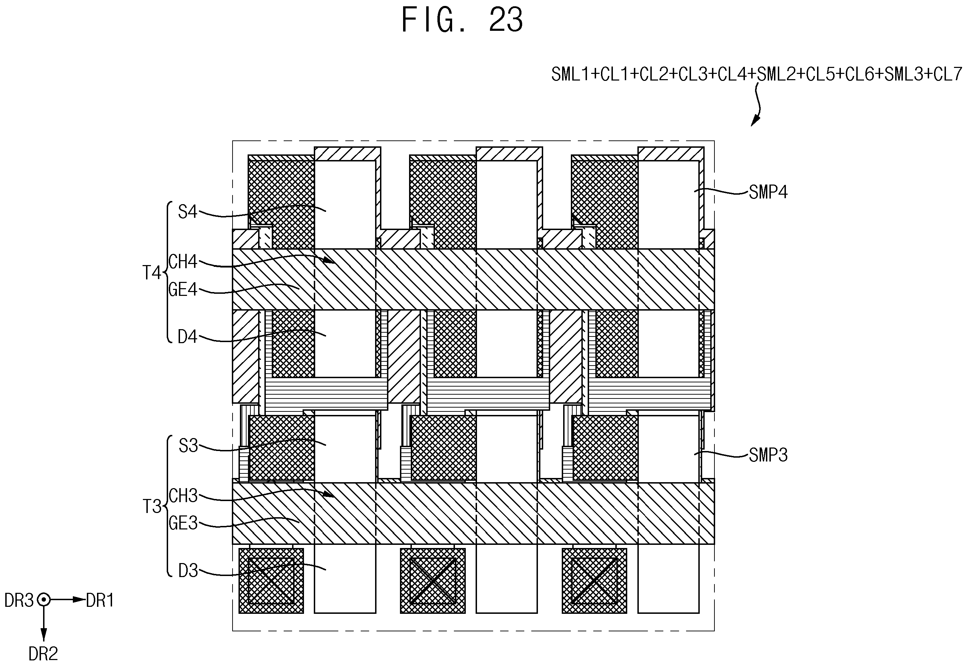

FIG. 22 illustrates the seventh conductive layer CL7, and FIG. 23 illustrates that the seventh conductive layer CL7 is further disposed in FIG. 21. As illustrated in FIGS. 4, 22, and 23, the seventh conductive layer CL7 may be disposed on the ninth insulating layer IL9.

The seventh conductive layer CL7 may include a conductive material. The seventh conductive layer CL7 may have a single-layer structure or a multi-layer structure including a plurality of conductive layers.

The seventh conductive layer CL7 may include a third gate electrode GE3 and a fourth gate electrode GE4. The third gate electrode GE3 and the fourth gate electrode GE4 may be spaced apart from each other in a plan view. In an embodiment, the third gate electrode GE3 may be spaced apart from the fourth gate electrode GE4 in the second direction DR2, for example.

In an embodiment, each of the third gate electrode GE3 and the fourth gate electrode GE4 may extend in the first direction DR1.

As illustrated in FIGS. 21 and 23, the third gate electrode GE3 may at least partially overlap the third semiconductor pattern SMP3 in a plan view. A portion of the third gate electrode GE3 may overlap the third channel area CH3 of the third semiconductor pattern SMP3 in a plan view. The portion of the third gate electrode GE3 overlapping the third channel area CH3 in a plan view may be the gate electrode of the third transistor T3. The second gate signal GC of FIG. 3 may be applied to the third gate electrode GE3. In an embodiment, the third gate electrode GE3 may correspond to the second gate line GCL of FIG. 3, for example.

As illustrated in FIGS. 21 and 23, the fourth gate electrode GE4 may at least partially overlap the fourth semiconductor pattern SMP4 in a plan view. A portion of the fourth gate electrode GE4 may overlap the fourth channel area CH4 of the fourth semiconductor pattern SMP4 in a plan view. The portion of the fourth gate electrode GE4 overlapping the fourth channel area CH4 in a plan view may be the gate electrode of the fourth transistor T4. The light-emitting signal EM of FIG. 3 may be applied to the fourth gate electrode GE4. In an embodiment, the fourth gate electrode GE4 may correspond to the light-emitting line EML of FIG. 3, for example.

The tenth insulating layer IL10 may be disposed on the seventh conductive layer CL7. The tenth insulating layer IL10 may include an inorganic insulating material and/or an organic insulating material. The tenth insulating layer IL10 may have a single-layer structure or a multi-layer structure including a plurality of insulating layers. The tenth insulating layer IL10 may cover the third gate electrode GE3 and the fourth gate electrode GE4.

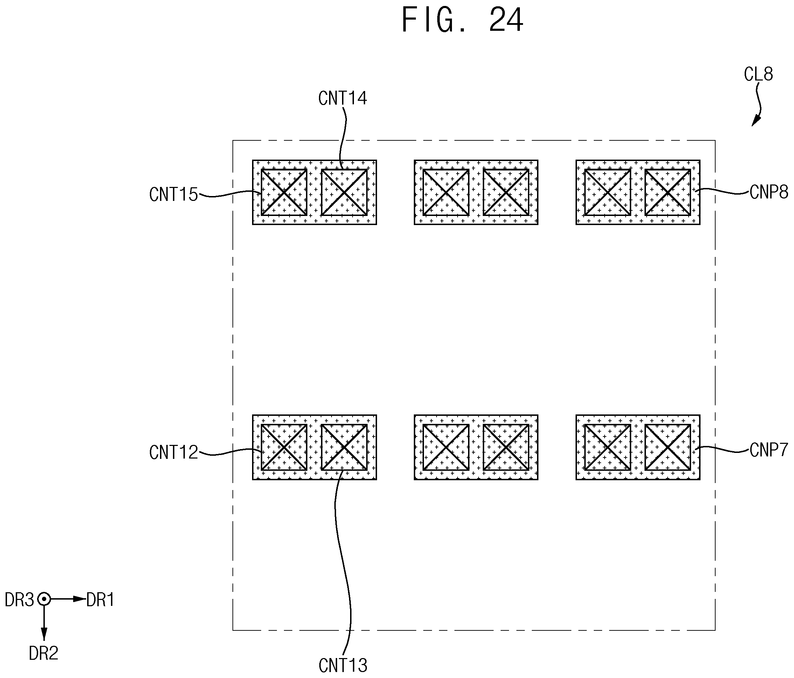

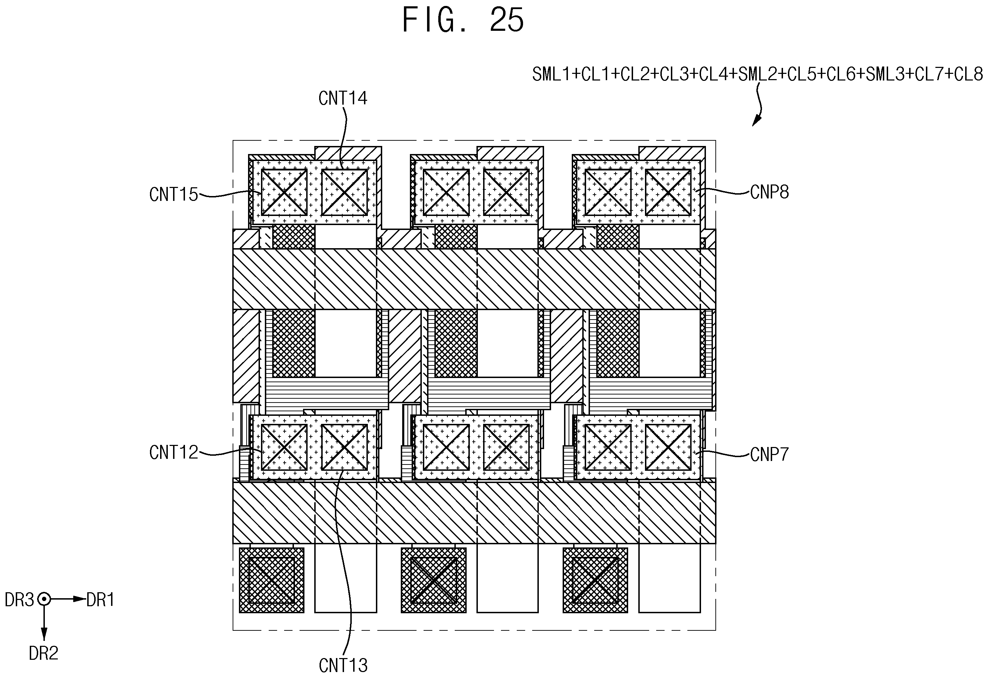

FIG. 24 illustrates the eighth conductive layer CL8, and FIG. 25 illustrates that the eighth conductive layer CL8 is further disposed in FIG. 23. As illustrated in FIGS. 4, 24, and 25, the eighth conductive layer CL8 may be disposed on the tenth insulating layer IL10.

The eighth conductive layer CL8 may include a conductive material. The eighth conductive layer CL8 may have a single-layer structure or a multi-layer structure including a plurality of conductive layers.

The eighth conductive layer CL8 may include a seventh connection pattern CNP7 and an eighth connection pattern CNP8. The seventh connection pattern CNP7 and the eighth connection pattern CNP8 may be spaced apart from each other in a plan view. In an embodiment, the seventh connection pattern CNP7 may be spaced apart from the eighth connection pattern CNP8 in the second direction DR2, for example.

As illustrated in FIGS. 19, 21, 23, and 25, the seventh connection pattern CNP7 may at least partially overlap each of the sixth connection pattern CNP6 and the third drain area D3 of the third semiconductor pattern SMP3 in a plan view.

The seventh connection pattern CNP7 may be connected to the sixth connection pattern CNP6 through a twelfth contact hole CNT12 penetrating a lower insulating layer (e.g., the eighth, ninth, and tenth insulating layers IL8, IL9, and IL10). In an embodiment, the twelfth contact hole CNT12 may expose a portion of the sixth connection pattern CNP6, and a portion of the seventh connection pattern CNP7 may contact the portion of the sixth connection pattern CNP6 exposed by the twelfth contact hole CNT12, for example.

In addition, the seventh connection pattern CNP7 may be connected to the third drain area D3 of the third semiconductor pattern SMP3 (i.e., the second electrode of the third transistor T3) through a thirteenth contact hole CNT13 penetrating a lower insulating layer (e.g., the ninth and tenth insulating layers IL9 and IL10). In an embodiment, the thirteenth contact hole CNT13 may expose a portion of the third drain area D3 of the third semiconductor pattern SMP3, and a portion of the seventh connection pattern CNP7 may contact the portion of the third drain area D3 of the third semiconductor pattern SMP3 exposed by the thirteenth contact hole CNT13, for example.

Accordingly, the seventh connection pattern CNP7 may electrically connect the sixth connection pattern CNP6 and the third drain area D3 of the third semiconductor pattern SMP3. That is, accordingly, the third drain area D3 of the third semiconductor pattern SMP3 (i.e., the second electrode of the third transistor T3) may be connected to the second source area S2 of the second semiconductor pattern SMP2 (i.e., the first electrode of the first transistor T1) through the seventh connection pattern CNP7 and the sixth connection pattern CNP6.

As illustrated in FIGS. 19, 21, 23, and 25, the eighth connection pattern CNP8 may at least partially overlap each of the fourth source area S4 of the fourth semiconductor pattern SMP4 and the fifth capacitor pattern CPE5 in a plan view.

The eighth connection pattern CNP8 may be connected to the fourth source area S4 of the fourth semiconductor pattern SMP4 (i.e., the first electrode of the fourth transistor T4) through a fourteenth contact hole CNT14 penetrating a lower insulating layer (e.g., the ninth and tenth insulating layers IL9 and IL10). In an embodiment, the fourteenth contact hole CNT14 may expose a portion of the fourth source area S4 of the fourth semiconductor pattern SMP4, and a portion of the eighth connection pattern CNP8 may contact the portion of the fourth source area S4 of the fourth semiconductor pattern SMP4 exposed by the fourteenth contact hole CNT14, for example.

In addition, the eighth connection pattern CNP8 may be connected to the fifth capacitor pattern CPE5 through a fifteenth contact hole CNT15 penetrating a lower insulating layer (e.g., the eighth, ninth, and tenth insulating layers IL8, IL9, and IL10). In an embodiment, the fifteenth contact hole CNT15 may expose a portion of the fifth capacitor pattern CPE5, and a portion of the eighth connection pattern CNP8 may contact the portion of the fifth capacitor pattern CPE5 exposed by the fifteenth contact hole CNT15, for example.

Accordingly, the eighth connection pattern CNP8 may electrically connect the fourth source area S4 of the fourth semiconductor pattern SMP4 and the fifth capacitor pattern CPE5. That is, the fourth source area S4 of the fourth semiconductor pattern SMP4 (i.e., the first electrode of the fourth transistor T4) may be connected to the fifth capacitor pattern CPE5 through the eighth connection pattern CNP8.

In addition, accordingly, the fourth source area S4 of the fourth semiconductor pattern SMP4 (i.e., the first electrode of the fourth transistor T4) may be connected to the second drain area D2 of the second semiconductor pattern SMP2 (i.e., the second electrode of the first transistor T1) through the eighth connection pattern CNP8, the fifth capacitor pattern CPE5, and the fourth connection pattern CNP4, and may be connected to the first capacitor pattern CPE1 (i.e., the second electrode of the second capacitor C2) through the eighth connection pattern CNP8, the fifth capacitor pattern CPE5, the fourth connection pattern CNP4, the fourth capacitor pattern CPE4, and the second connection pattern CNP2.

The eleventh insulating layer IL11 may be disposed on the eighth conductive layer CL8. The eleventh insulating layer IL11 may include an inorganic insulating material and/or an organic insulating material. The eleventh insulating layer IL11 may have a single-layer structure or a multi-layer structure including a plurality of insulating layers. The eleventh insulating layer IL11 may cover the seventh connection pattern CNP7 and the eighth connection pattern CNP8.

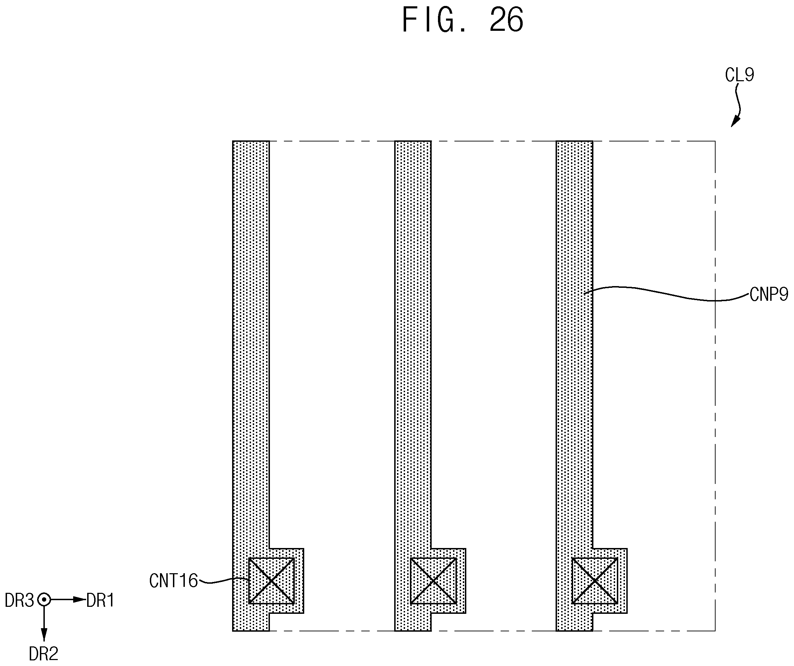

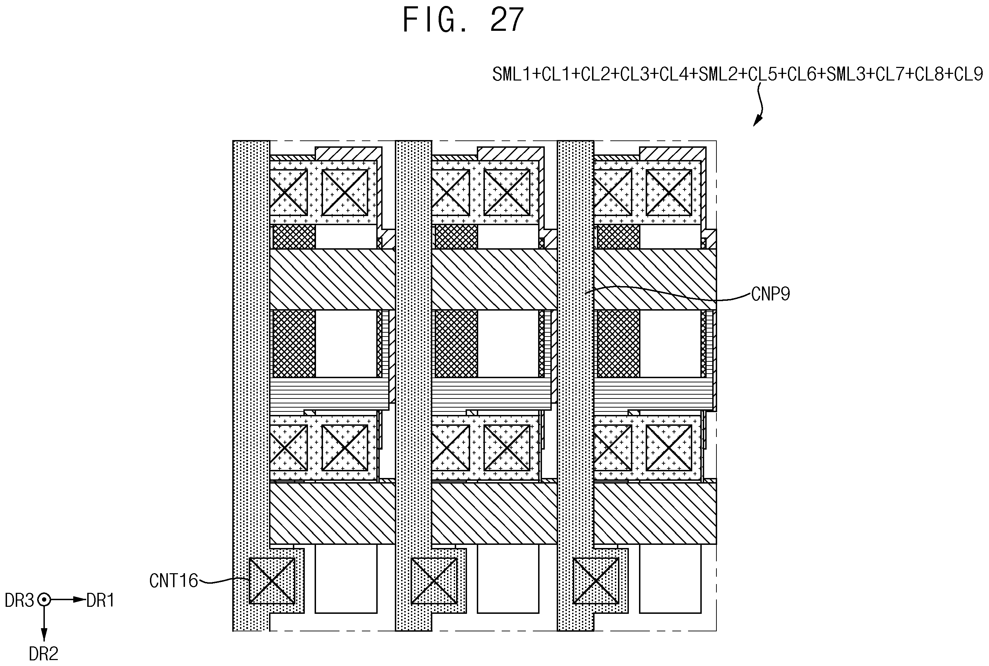

FIG. 26 illustrates the ninth conductive layer CL9, and FIG. 27 illustrates that the ninth conductive layer CL9 is further disposed in FIG. 25. As illustrated in FIGS. 4, 26, and 27, the ninth conductive layer CL9 may be disposed on the eleventh insulating layer IL11.

The ninth conductive layer CL9 may include a conductive material. The ninth conductive layer CL9 may have a single-layer structure or a multi-layer structure including a plurality of conductive layers.

The ninth conductive layer CL9 may include a ninth connection pattern CNP9. In an embodiment, the ninth connection pattern CNP9 may extend in the second direction DR2.

As illustrated in FIGS. 19, 25, and 27, the ninth connection pattern CNP9 may at least partially overlap the fifth connection pattern CNP5 in a plan view. The ninth connection pattern CNP9 may be connected to the fifth connection pattern CNP5 through a sixteenth contact hole CNT16 penetrating a lower insulating layer (e.g., the eighth, ninth, tenth, and eleventh insulating layers IL8, IL9, IL10, and IL11). In an embodiment, the sixteenth contact hole CNT16 may expose a portion of the fifth connection pattern CNP5, and a portion of the ninth connection pattern CNP9 may contact the portion of the fifth connection pattern CNP5 exposed by the sixteenth contact hole CNT16, for example.

Accordingly, the ninth connection pattern CNP9 may be connected to the first source area S1 of the first semiconductor pattern SMP1 (i.e., the first electrode of the second transistor T2) through the fifth connection pattern CNP5, the third connection pattern CNP3, and the first connection pattern CNP1.

The data voltage DATA of FIG. 3 may be applied to the ninth connection pattern CNP9. In an embodiment, the ninth connection pattern CNP9 may correspond to the data line DL of FIG. 3, for example. That is, accordingly, the data voltage DATA of FIG. 3 may be applied to the first source area S1 of the first semiconductor pattern SMP1 (i.e., the first electrode of the second transistor T2) through the ninth connection pattern CNP9.

The twelfth insulating layer IL12 may be disposed on the ninth conductive layer CL9. The twelfth insulating layer IL12 may include an inorganic insulating material and/or an organic insulating material. The twelfth insulating layer IL12 may have a single-layer structure or a multi-layer structure including a plurality of insulating layers. The twelfth insulating layer IL12 may cover the ninth connection pattern CNP9.

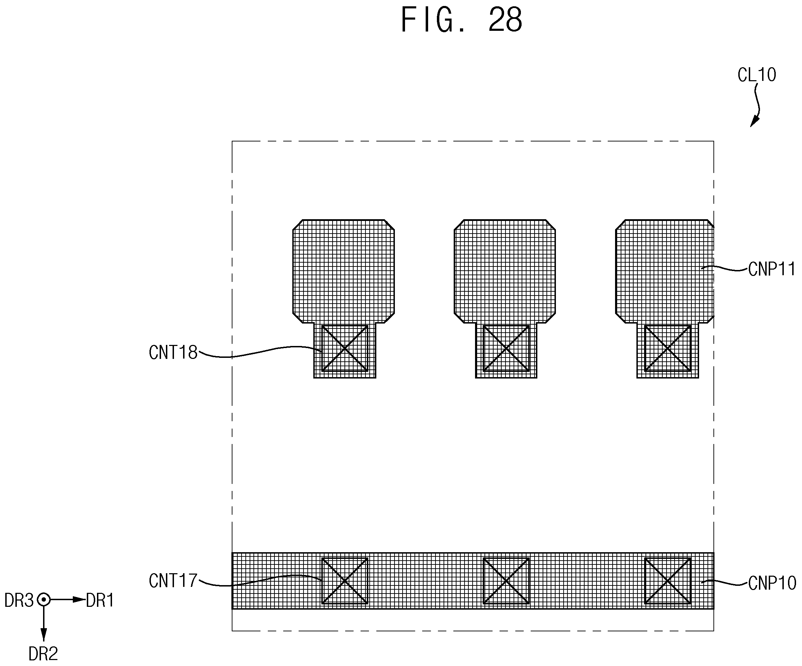

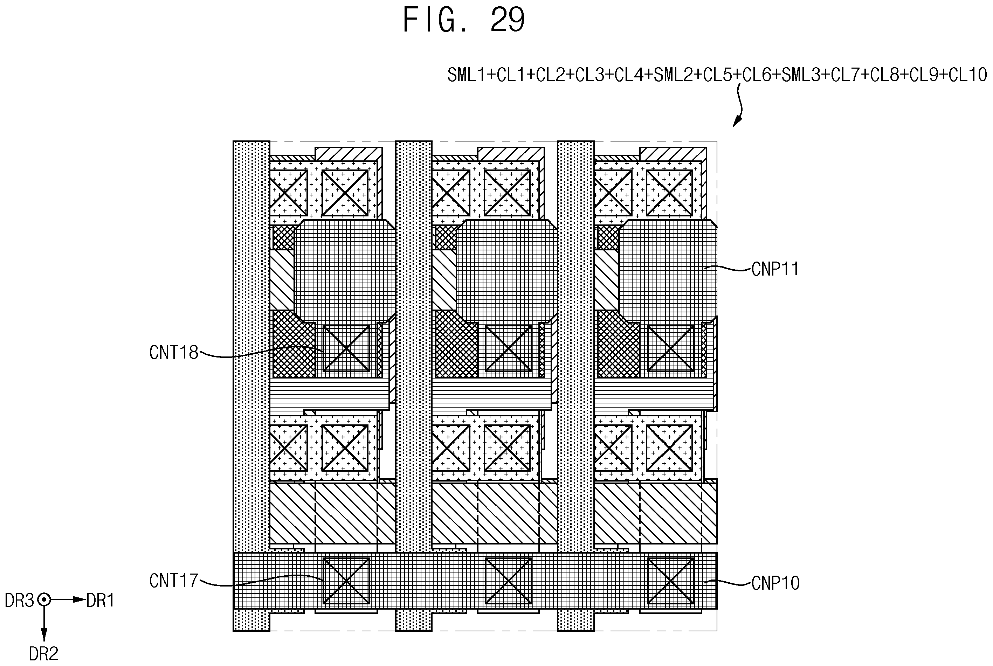

FIG. 28 illustrates the tenth conductive layer CL10, and FIG. 29 illustrates that the tenth conductive layer CL10 is further disposed in FIG. 27. As illustrated in FIGS. 4, 28, and 29, the tenth conductive layer CL10 may be disposed on the twelfth insulating layer IL12.

The tenth conductive layer CL10 may include a conductive material. The tenth conductive layer CL10 may have a single-layer structure or a multi-layer structure including a plurality of conductive layers.

The tenth conductive layer CL10 may include a tenth connection pattern CNP10 and an eleventh connection pattern CNP11. The tenth connection pattern CNP10 and the eleventh connection pattern CNP11 may be spaced apart from each other in a plan view. In an embodiment, the tenth connection pattern CNP10 may be spaced apart from the eleventh connection pattern CNP11 in the second direction DR2, for example.

In an embodiment, the tenth connection pattern CNP10 may extend in the first direction DR1. As illustrated in FIGS. 21, 27, and 29, the tenth connection pattern CNP10 may at least partially overlap the third source area S3 of the third semiconductor pattern SMP3 in a plan view. The tenth connection pattern CNP10 may be connected to the third source area S3 of the third semiconductor pattern SMP3 (i.e., the first electrode of the third transistor T3) through a seventeenth contact hole CNT17 penetrating a lower insulating layer (e.g., the ninth, tenth, eleventh, and twelfth insulating layers IL9, IL10, IL11, and IL12). In an embodiment, the seventeenth contact hole CNT17 may expose a portion of the third source area S3 of the third semiconductor pattern SMP3, and a portion of the tenth connection pattern CNP10 may contact the portion of the third source area S3 of the third semiconductor pattern SMP3 exposed by the seventeenth contact hole CNT17, for example.

The first power voltage ELVDD of FIG. 3 may be applied to the tenth connection pattern CNP10. In an embodiment, the tenth connection pattern CNP10 may correspond to the first power line VDL of FIG. 3, for example. That is, accordingly, the first power voltage ELVDD of FIG. 3 may be applied to the third source area S3 of the third semiconductor pattern SMP3 (i.e., the first electrode of the third transistor T3) through the tenth connection pattern CNP10.

As illustrated in FIGS. 21, 27, and 29, the eleventh connection pattern CNP11 may at least partially overlap the fourth drain area D4 of the fourth semiconductor pattern SMP4 in a plan view. The eleventh connection pattern CNP11 may be connected to the fourth drain area D4 of the fourth semiconductor pattern SMP4 (i.e., the second electrode of the fourth transistor T4) through an eighteenth contact hole CNT18 penetrating a lower insulating layer (e.g., the ninth, tenth, eleventh, and twelfth insulating layers IL9, IL10, IL11, and IL12). In an embodiment, the eighteenth contact hole CNT18 may expose a portion of the fourth drain area D4 of the fourth semiconductor pattern SMP4, and a portion of the eleventh connection pattern CNP11 may contact the portion of the fourth drain area D4 of the fourth semiconductor pattern SMP4 exposed by the eighteenth contact hole CNT18, for example.

The thirteenth insulating layer IL13 may be disposed on the tenth conductive layer CL10. The thirteenth insulating layer IL13 may include an inorganic insulating material and/or an organic insulating material. The thirteenth insulating layer IL13 may have a single-layer structure or a multi-layer structure including a plurality of insulating layers. The thirteenth insulating layer IL13 may cover the tenth connection pattern CNP10 and the eleventh connection pattern CNP11.

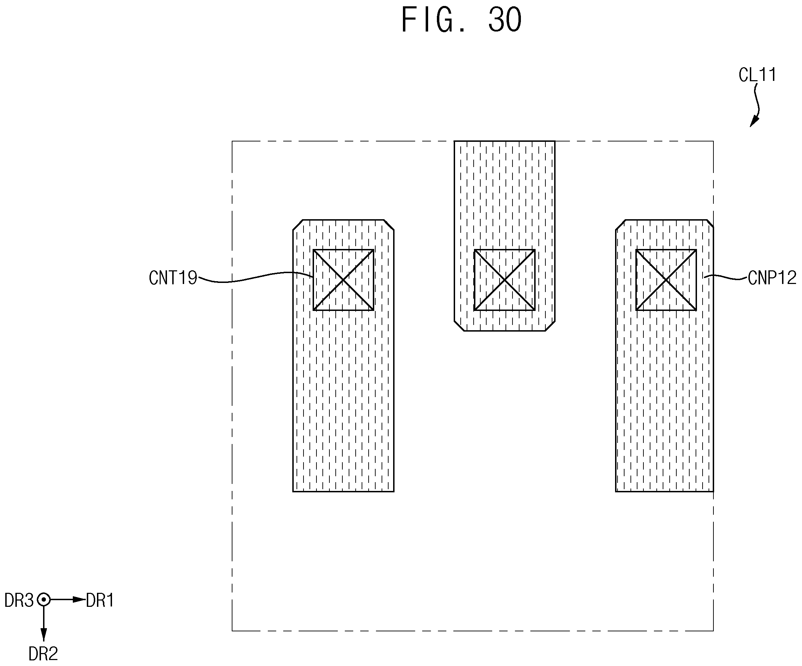

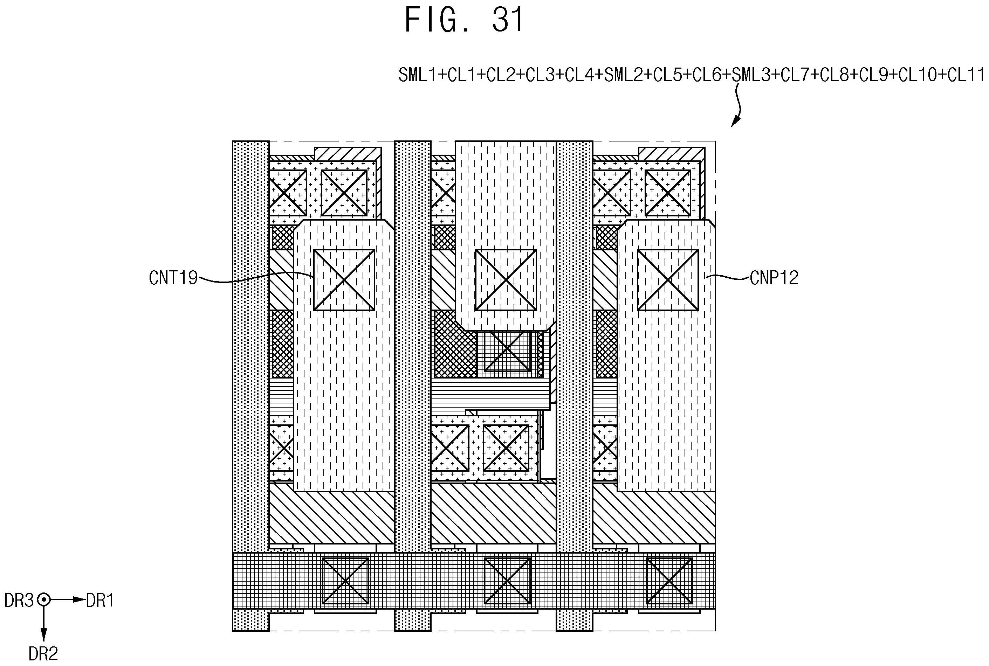

FIG. 30 illustrates the eleventh conductive layer CL11, and FIG. 31 illustrates that the eleventh conductive layer CL11 is further disposed in FIG. 29. As illustrated in FIGS. 4, 30, and 31, the eleventh conductive layer CL11 may be disposed on the thirteenth insulating layer IL13.

The eleventh conductive layer CL11 may include a conductive material. The eleventh conductive layer CL11 may have a single-layer structure or a multi-layer structure including a plurality of conductive layers.

The eleventh conductive layer CL11 may include a twelfth connection pattern CNP12.

As illustrated in FIGS. 29 and 31, the twelfth connection pattern CNP12 may at least partially overlap the eleventh connection pattern CNP11 in a plan view. The twelfth connection pattern CNP12 may be connected to the eleventh connection pattern CNP11 through a nineteenth contact hole CNT19 penetrating a lower insulating layer (e.g., the thirteenth insulating layer IL13). In an embodiment, the nineteenth contact hole CNT19 may expose a portion of the eleventh connection pattern CNP11, and a portion of the twelfth connection pattern CNP12 may contact the portion of the eleventh connection pattern CNP11 exposed by the nineteenth contact hole CNT19, for example.

The fourteenth insulating layer IL14 may be disposed on the eleventh conductive layer CL11. The fourteenth insulating layer IL14 may include an inorganic insulating material and/or an organic insulating material. The fourteenth insulating layer IL14 may have a single-layer structure or a multi-layer structure including a plurality of insulating layers. The fourteenth insulating layer IL14 may cover the twelfth connection pattern CNP12.

As illustrated in FIG. 4, the display panel PN may further include the light-emitting element LE and a pixel defining layer PDL arranged on the fourteenth insulating layer IL14. The light-emitting element LE may include a first electrode E1, a light-emitting layer EL, and a second electrode E2.

The first electrode E1 may be disposed on the fourteenth insulating layer IL14. The first electrode E1 may include a conductive material. In an embodiment, the first electrode E1 may be the first electrode (e.g., an anode) of the light-emitting element LE, for example.

The first electrode E1 may be connected to the twelfth connection pattern CNP12 through a contact hole penetrating a lower insulating layer (e.g., the fourteenth insulating layer IL14). Accordingly, the first electrode E1 may be connected to the fourth drain area D4 of the fourth semiconductor pattern SMP4 (i.e., the second electrode of the fourth transistor T4) through the twelfth connection pattern CNP12 and the eleventh connection pattern CNP11. That is, accordingly, the light-emitting element LE and the pixel circuit PC may be electrically connected.

The pixel defining layer PDL may be disposed on the fourteenth insulating layer IL14 and the first electrode E1. The pixel defining layer PDL may cover a peripheral portion of the first electrode E1, and may define an opening exposing at least a portion of the first electrode E1. The pixel defining layer PDL may include an inorganic insulating material and/or an organic insulating material.

The light-emitting layer EL may be disposed on the first electrode E1. The light-emitting layer EL may be disposed on the first electrode E1 exposed by the opening of the pixel defining layer PDL. The light-emitting layer EL may include a light-emitting material that emits light of a selected color.

The second electrode E2 may be disposed on the light-emitting layer EL and the pixel defining layer PDL. The second electrode E2 may include a conductive material. In an embodiment, the second electrode E2 may be the second electrode (e.g., a cathode) of the light-emitting element LE, for example.

Although FIG. 4 illustrates that the first sub-capacitor C1_1, the second capacitor C2, the second sub-capacitor C1_2, and the third sub-capacitor C1_3 are sequentially arranged along the third direction DR3, the invention is not limited thereto. The cross-sectional arrangement of the first, second, and third sub-capacitors C1_1, C1_2, and C1_3 and the second capacitor C2 may be variously changed while the first, second, and third sub-capacitors C1_1, C1_2, and C1_3 and the second capacitor C2 at least partially overlap each other in a plan view.

In the display device DD according to the invention, the transistors T1, T2, T3, and T4 of the pixel circuit PC of the pixel PX included in the display panel PN may be implemented as a multi-layer structure stacked in the third direction DR3. In addition, the first capacitor C1 of the pixel circuit PC may be implemented as a multi-capacitor structure stacked in the third direction DR3. Accordingly, the degree of integration of the pixel circuits PC may be further improved, and the resolution of the display device DD may be further improved. In an embodiment, the resolution of the display device DD may be about 1500 pixels per inch (ppi) or more, for example.

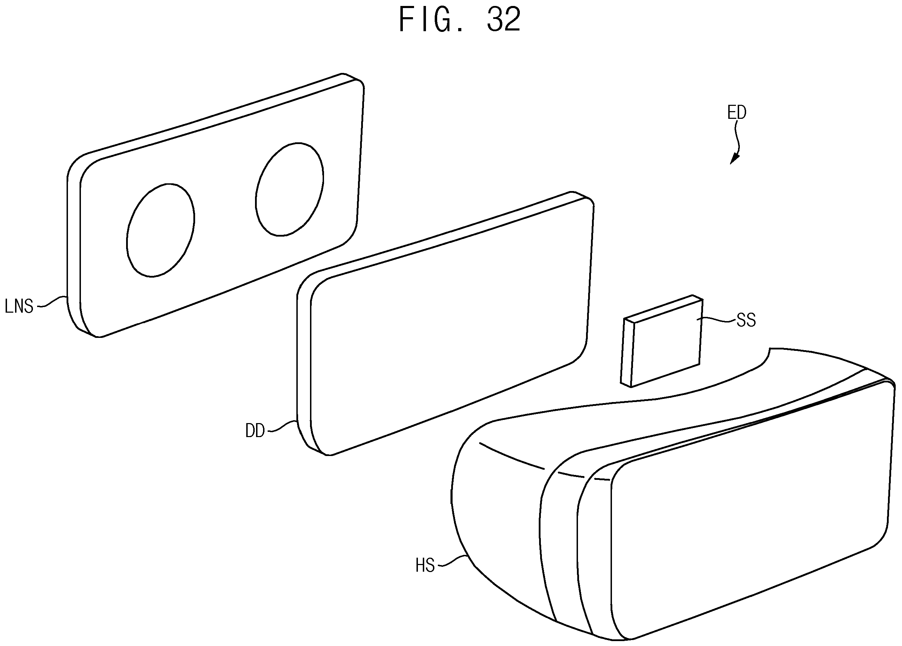

FIG. 32 is an exploded perspective view illustrating an embodiment of an electronic device according to the invention.

Referring to FIG. 32, an electronic device ED in an embodiment may include a lens LNS, a display device DD, a sensor SS, and a housing HS. In an embodiment, the electronic device ED may be an electronic device for virtual reality ("VR") worn on a user's head. The display device DD may be the display device DD described with reference to FIGS. 1 to 31. That is, the display device DD described with reference to FIGS. 1 to 31 may be implemented as a head-mounted display device, and may display a VR image.

In an embodiment, the sensor SS may include a camera, but is not limited thereto, and the sensor SS may include various types of sensors capable of tracking the user's gaze. The display device DD may be disposed next (adjacent) to the lens LNS. The housing HS may accommodate (or house) the lens LNS, the display device DD, and the sensor SS.

Although FIG. 32 illustrates that the lens LNS, the display device DD, and the sensor SS are accommodated in one side of the housing HS, the invention is not limited thereto. In addition, the electronic device ED may further include a strap to be worn on the user's head, a cushion to improve wearability, or the like.

The invention may be applied to various display devices and electronic devices. In an embodiment, the invention is applicable to various display devices such as display devices for vehicles, ships and aircraft, portable communication devices, display devices for exhibition or information transmission, medical display devices, or the like.

The foregoing is illustrative of embodiments and is not to be construed as limiting thereof. Although a few embodiments have been described, those skilled in the art will readily appreciate that many modifications are possible in the embodiments without materially departing from the novel teachings and advantages of the inventive concept. Accordingly, all such modifications are intended to be included within the scope of the inventive concept as defined in the claims. Therefore, it is to be understood that the foregoing is illustrative of various embodiments and is not to be construed as limited to the illustrative embodiments disclosed, and that modifications to the disclosed embodiments, as well as other embodiments, are intended to be included within the scope of the appended claims.

## Claims

1. A display device (DD) comprising:
a light-emitting element (LE);
a first transistor (T1) which generates a driving current applied to the light-emitting element (LE), the first transistor (T1) including:
a first channel area (CH2);
a second transistor (T2) which applies a data voltage (DATA) to the first transistor (T1) in response to a first gate signal (GW), the second transistor (T2) including:
a second channel area (CH1) disposed in a different layer from the first channel area (CH2);
a third transistor (T3) which applies a power voltage (ELVDD) to the first transistor (T1) in response to a second gate signal (GC), the third transistor (T3) including:
a third channel area (CH3) disposed in a different layer from each of the first channel area (CH2) and the second channel area (CH1); and
a fourth transistor (T4) which electrically connects the first transistor (T1) and the light-emitting element (LE) in response to a light-emitting signal (EM), the fourth transistor (T4) including:
a fourth channel area (CH4) disposed in a different layer from each of the first channel area (CH2) and the second channel area (CH1).

2. The display device (DD) of claim 1, wherein
the first channel area (CH2) is disposed in a first semiconductor layer (SML2), and
the second channel area (CH1) is disposed in a second semiconductor layer (SML1) on which the first semiconductor layer (SML2) is disposed.

3. The display device (DD) of claim 2, wherein the third channel area (CH3) and the fourth channel area (CH4) are disposed in a third semiconductor layer (SML3) disposed on the first semiconductor layer (SML2).

4. The display device (DD) of claim 3, wherein the first semiconductor layer (SML2) is disposed between the second semiconductor layer (SML1) and the third semiconductor layer (SML3).

5. The display device (DD) of claim 3 or 4, wherein
the first semiconductor layer (SML2) includes:
a first semiconductor pattern (SMP2) including the first channel area (CH2), a first source area (S2), and a first drain area (D2),
the second semiconductor layer (SML1) includes:
a second semiconductor pattern (SMP1) including the second channel area (CH1), a second source area (S1), and a second drain area (D1), and at least partially overlapping the first semiconductor pattern (SMP2) in a plan view, and
the third semiconductor layer (SML3) includes:
a third semiconductor pattern (SMP3) including the third channel area (CH3), a third source area (S3), and a third drain area (D3), and at least partially overlapping each of the first semiconductor pattern (SMP2) and the second semiconductor pattern (SMP1) in the plan view; and
a fourth semiconductor pattern (SMP4) including the fourth channel area (CH4), a fourth source area (S4), and a fourth drain area (D4), at least partially overlapping each of the first semiconductor pattern (SMP2) and the second semiconductor pattern (SMP1) in the plan view, and spaced apart from the third semiconductor pattern (SMP3).

6. The display device (DD) of claim 5, further comprising:
a first capacitor pattern (CPE1) disposed in a first conductive layer (CL1) disposed between the first semiconductor layer (SML2) and the second semiconductor layer (SML1),
wherein the first capacitor pattern (CPE1) at least partially overlaps the second drain area (D1) in the plan view, and
the second drain area (D1) and the first capacitor pattern (CPE1) define a first sub-capacitor (C1_1).

7. The display device (DD) of claim 6, further comprising:
a second capacitor pattern (CPE3) disposed in a second conductive layer (CL3) disposed between the first conductive layer (CL1) and the first semiconductor layer (SML2); and
a third capacitor pattern (CPE4) disposed in a third conductive layer (CL4) disposed between the second conductive layer (CL3) and the first semiconductor layer (SML2),
wherein the second capacitor pattern (CPE3) at least partially overlaps each of the second drain area (D1) and the first capacitor pattern (CPE1) in the plan view,
the third capacitor pattern (CPE4) at least partially overlaps each of the second drain area (D1), the first capacitor pattern (CPE1), and the second capacitor pattern (CPE3) in the plan view, and
the second capacitor pattern (CPE3) and the third capacitor pattern (CPE4) define a second sub-capacitor (C1_2).

8. The display device (DD) of claim 7, further comprising:
a first gate electrode (GE2) disposed in a fourth conductive layer (CL5) disposed between the first semiconductor layer (SML2) and the third semiconductor layer (SML3),
wherein the first gate electrode (GE2) at least partially overlaps each of the first channel area (CH2), the second drain area (D1), the first capacitor pattern (CPE1), the second capacitor pattern (CPE3), and the third capacitor pattern (CPE4) in the plan view.

9. The display device (DD) of claim 8, further comprising:
a fourth capacitor pattern (CPE5) disposed in a fifth conductive layer (CL6) disposed between the fourth conductive layer (CL5) and the third semiconductor layer (SML3),
wherein the fourth capacitor pattern (CPE5) at least partially overlaps each of the second drain area (D1), the first capacitor pattern (CPE1), the second capacitor pattern (CPE3), the third capacitor pattern (CPE4), and the first gate electrode (GE2) in the plan view, and
the first gate electrode (GE2) and the fourth capacitor pattern (CPE5) define a third sub-capacitor (C1_3).

10. The display device (DD) of claim 9, wherein
the second drain area (D1), the second capacitor pattern (CPE3), and the first gate electrode (GE2) are electrically connected to each other, and
the first capacitor pattern (CPE1), the third capacitor pattern (CPE4), and the fourth capacitor pattern (CPE5) are electrically connected to each other.

11. The display device (DD) of claim 9 or 10, wherein the first sub-capacitor (C1_1), the second sub-capacitor (C1_2), and the third sub-capacitor (C1_3) at least partially overlap each other in the plan view.

12. The display device (DD) of at least one of claims 8 to 11, further comprising:
a first capacitor (C1) including a first electrode electrically connected to the first gate electrode (GE2) and a second electrode electrically connected to the first capacitor pattern (CPE1); and
a second capacitor (C2) including a first electrode to which a reference voltage (VREF) is applied and a second electrode electrically connected to the first capacitor (C1).

13. The display device (DD) of claim 12, wherein the first capacitor (C1) includes the first sub-capacitor (C1_1), the second sub-capacitor (C1_2), and the third sub-capacitor (C1_3).

14. The display device (DD) of at least one of claims 9 to 13, further comprising:
a fifth capacitor pattern (CPE2) disposed in a sixth conductive layer (CL2) disposed on the first conductive layer (CL1),
wherein the fifth capacitor pattern (CPE2) at least partially overlaps each of the second drain area (D1), the first capacitor pattern (CPE1), the second capacitor pattern (CPE3), the third capacitor pattern (CPE4), the first gate electrode (GE2), and the fourth capacitor pattern (CPE5) in the plan view, and
the first capacitor pattern (CPE1) and the fifth capacitor pattern (CPE2) define the second capacitor (C2).

15. The display device (DD) of at least one of claims 12 to 14, wherein the second capacitor (C2) at least partially overlaps each of the first sub-capacitor (C1_1), the second sub-capacitor (C1_2), and the third sub-capacitor (C1_3) in the plan view.

16. The display device (DD) of at least one of claims 8 to 15, wherein the first semiconductor pattern (SMP2) and the first gate electrode (GE2) define the first transistor (T1).

17. The display device (DD) of at least one of claims 8 to 16, further comprising:
a second gate electrode (GE1) disposed in the first conductive layer (CL1),
wherein the second gate electrode (GE1) is spaced apart from the first capacitor pattern (CPE1) and at least partially overlaps the second channel area (CH1) in the plan view, and
the second semiconductor pattern (SMP1) and the second gate electrode (GE1) define the second transistor (T2).

18. The display device (DD) of claim 17, further comprising:
a third gate electrode (GE3) disposed in a seventh conductive layer (CL7) disposed on the third semiconductor layer (SML3),
wherein the third gate electrode (GE3) at least partially overlaps the third channel area (CH3) in the plan view, and
the third semiconductor pattern (SMP3) and the third gate electrode (GE3) define the third transistor (T3).

19. The display device (DD) of claim 18, further comprising:
a fourth gate electrode (GE4) disposed in the seventh conductive layer,
wherein the fourth gate electrode (GE4) is spaced apart from the third gate electrode (GE3) and at least partially overlaps the fourth channel area (CH4), and
the fourth semiconductor pattern (SMP4) and the fourth gate electrode (GE4) define the fourth transistor (T4).

20. An electronic device (ED) comprising:
a housing (HS); and
a display device (DD) according to at least one of claims 1 to 19 which is accommodated in the housing (HS) and displays an image.
